# EUROPEAN PATENT APPLICATION

(11) **EP 2 290 733 A1**
(43) Date of publication of application: **02.03.2011**
(21) Application number: 10251325.6
(22) Date of filing: 26.07.2010
(51) Int. Cl.: H01M 2/20, H01M 10/48, G01R 31/36

(54) **Battery system and electric vehicle including the same**

(30) Priority: 30.07.2009 JP 2009178222; 22.07.2010 JP 2010164500
(71) Applicant: Sanyo Electric Co., Ltd., Osaka 570-8677 (JP)
(72) Inventor: Kishimoto, Keiji, Moriguchi-City Osaka 570-8677 (JP); Nishihara, Yoshitomo, Moriguchi-City Osaka 570-8677 (JP); Ohkura, Kazumi, Moriguchi-City Osaka 570-8677 (JP)
(74) Representative: Calderbank, Thomas Roger

(57) **Abstract**

A battery system includes a plurality of battery modules each including one or a plurality of battery cells, and a detecting circuit that is used in common for the plurality of battery modules and detects a terminal voltage of each battery cell.

## Description

The present invention relates to a battery system including a battery module, and an electric vehicle.

Chargeable and dischargeable battery modules are used as driving sources of movable objects such as electric automobiles. Such a battery module includes a plurality of batteries (battery cells) connected in series, for example.

Users of the movable object including the battery module need to know the remaining amount (charged capacity) of the battery module. In addition, it is necessary to prevent overcharge and overdischarge of each cell constituting the battery module at the time of charging / discharging the battery module. Therefore, a device for monitoring a state of the battery module has been proposed (see JP 8-162171 A, for example).

JP 8-162171 A describes the monitoring device of a battery pack including the plurality of modules connected in series. The monitoring device is provided with a plurality of voltage measuring units that correspond to the plurality of battery modules, respectively. Each voltage measuring unit includes a voltage detecting circuit connected to a positive electrode terminal and a negative electrode terminal of the corresponding battery module. Thus, the voltage between the both terminals of the battery module is detected by the voltage detecting circuit.

A great number of battery modules are provided in the battery system that is used as the driving source of the movable object in order to provide a given driving force.

When the monitoring device of Patent Document 1 is applied to such a system, a great number of voltage measuring units need to be provided corresponding to the battery modules. In this case, the configuration of the battery system becomes complicated, resulting in increased cost.

An object of the present invention is to provide a battery system in which complicated configuration and increased cost can be suppressed and capacity can be increased, and an electric vehicle including the same.
(1) According to an aspect of the present invention, a battery system includes a plurality of battery modules each including a plurality of battery cells, and a voltage detector that is used in common for the plurality of battery modules and detects a terminal voltage of each battery cell.
   In the battery system according to the one aspect of the present invention, the terminal voltage of each battery cell in the plurality of battery modules is detected by the voltage detector that is used in common for the battery modules. Therefore, the number of voltage detectors is smaller than the number of the battery modules. As a result, complicated configuration and increased cost can be suppressed and larger capacity can be realized in the battery system.
   Note that each battery module includes the plurality of battery cells integrally fixed to one another in the present invention.
(2) The voltage detector may be arranged between any ones of the plurality of battery modules and held by a holding member.
   In this case, wiring between any ones of the plurality of battery modules and the voltage detector can be shortened.
(3) The holding member may be integrated with any of the plurality of battery modules.
   In this case, the voltage detector is integrally attached to any of the battery modules via the holding member. This allows the voltage detector and the battery module to be integrally handled, thus facilitating assembly of the battery system.
(4) The battery system may further include a holding member arranged to hold the voltage detector, wherein each of the plurality of battery modules may be arranged adjacent to another battery module, and the holding member may be provided in a position, which is not a position between battery modules that are adjacent to each other of the plurality of battery modules.
   The battery modules generate heat when being charged / discharged. Therefore, if the voltage detector is arranged between the battery modules that are adjacent to each other, the voltage detector is easily affected by the heat generated by each battery module. Also, this degrades heat dissipation characteristics of the voltage detector.
   Contrary to this, the holding member is provided in the position, which is not the position between the battery modules that are adjacent to each other of the plurality of battery modules. In this state, the voltage detector is held by the holding member.
   This inhibits the heat generated by each battery module from affecting the voltage detector, thus improving the heat dissipation characteristics of the voltage detector.
(5) The holding member is integrated with any of the plurality of battery modules. In this case, the voltage detector is integrally attached to any of the battery modules via the holding member. This allows the voltage detector and the battery module to be integrally handled, thus facilitating assembly of the battery system.
(6) Each of the battery modules may include a connecting member arranged to connect electrodes of adjacent battery cells to each other, a flexible member attached to the connecting member, and a plurality of voltage detection lines that are provided in the flexible member and connected between the voltage detector and the connecting member.
   In this case, the electrodes of the adjacent battery cells are connected to each other through the connecting member, and the plurality of voltage detection lines provided in the flexible member are connected between the voltage detector and the connecting member. This causes the terminal voltages of the plurality of battery cells to be detected.
   The plurality of voltage detection lines are provided in the flexible member, thereby sufficiently preventing a short from occurring in the voltage detection lines, and the voltage detection lines are reliably connected to the connecting member.
(7) First and second battery module groups each including the plurality of battery modules may be formed, the voltage detector may be provided in each of the first and second battery module groups as each of first and second voltage detectors, the first voltage detector may be used in common for the plurality of battery modules of the first battery module group, and detect the terminal voltage of each battery cell of the first battery module group, the second voltage detector may be used in common for the plurality of battery modules of the second battery module group, and detect the terminal voltage of each battery cell of the second battery module group, the plurality of battery modules of the first battery module group may be arranged along a first direction, the plurality of battery modules of the second battery module group may be arranged along the first direction, the first and second battery module groups may be arranged adjacent to each other in a second direction perpendicular to the first direction, and the first and second voltage detectors may be arranged adjacent to each other in the second direction, and connected so as to communicate with each other through a communication line.
   In this case, the first and second battery module groups are arranged adjacent to each other in the second direction. The first and second voltage detectors are provided in the first and second battery module groups, respectively. The first and second voltage detectors are arranged adjacent to each other in the second direction, thus decreasing a distance between the first and second voltage detectors. Also, the communication line connecting the first voltage detector and the second voltage detector can be shortened. As a result, the simplified communication line is realized.
(8) According to another aspect of the present invention, an electric vehicle includes the battery system according to the one aspect of the present invention, a motor driven by electric power supplied from the plurality of battery modules of the battery system; and a drive wheel rotated by a torque generated by the motor.
   In the electric vehicle according to the another aspect of the present invention, the motor is driven by the electric power supplied from the battery modules included in the battery system according to the one aspect of the present invention. The torque generated by the motor causes the drive wheel to rotate, so that the electric vehicle moves.
   The terminal voltage of each battery cell in the plurality of battery modules is detected by the voltage detector that is used in common for the battery modules. Therefore, the number of voltage detectors is smaller than the number of the battery modules. As a result, complicated configuration and increased cost can be suppressed and larger capacity can be realized.
   This allows for increased driving time and reduced cost of the electric vehicle. Note that each battery module includes the plurality of battery cells integrally fixed to one another.
   Other features, elements, characteristics, and advantages of the present invention will become more apparent from the following description of preferred embodiments of the present invention with reference to the attached drawings.

### In the drawings

Fig. 1 is a block diagram showing the schematic configuration of a battery system according to a first embodiment;
Fig. 2 is a block diagram showing the configuration of a module group of Fig. 1;
Fig. 3 is an external perspective view of a battery module;
Fig. 4 is a plan view of the battery module;
Fig. 5 is an end view of the battery module;
Fig. 6 shows external perspective views of bus bars;
Fig. 7 is an external perspective view of FPC boards to which a plurality of bus bars and a plurality of PTC elements are attached;
Fig. 8 is a schematic plan view for explaining connection between the bus bars and a detecting circuit;
Fig. 9 is a block diagram showing an example of the configuration of the detecting circuit;
Fig. 10 (a) is a plan view showing the arrangement of the module group included in the battery system according to the first embodiment;
Fig. 10 (b) is an end view of one battery module that is seen from the line A-A of Fig. 10(a) ;
Fig. 11 is a plan view showing the arrangement of a module group included in a battery system according to a second embodiment;
Fig. 12 (a) is a plan view showing the arrangement of a module group in a battery system according to a third embodiment;
Fig. 12 (b) is a diagram showing one surface of a printed circuit board of Fig. 12 (a);
Fig. 12 (c) is a diagram showing the other surface of the printed circuit board of Fig. 12(a) ;
Fig. 13 (a) is a plan view showing the arrangement of a module group in a battery system according to a fourth embodiment;
Fig. 13 (b) is an end view of one battery module that is seen from the line B-B of Fig. 13(a) ;
Fig. 14 (a) is a plan view showing the arrangement of a module group in a battery system according to a fifth embodiment;
Fig. 14 (b) is an end view of the module group of Fig. 14 (a) that is seen from the side of its one end surface;
Fig. 15 is a schematic plan view of a battery system according to a sixth embodiment;
Fig. 16 (a) is an enlarged plan view of one module group of Fig. 15;
Fig. 16 (b) is an enlarged plan view of the other module group of Fig. 15;
Fig. 17 is a schematic plan view of a battery system according to a seventh embodiment;
Fig. 18 is a schematic plan view showing another example of connection of communication lines in the battery system according to the seventh embodiment;
Fig. 19 is a schematic plan view of a battery system according to an eighth embodiment;
Fig. 20 is a plan view of an FPC board used in a battery system according to the eighth embodiment;
Fig. 21 is a schematic plan view of a battery system according to a ninth embodiment;
Fig. 22 is a plan view of an FPC board used in a battery system according to the ninth embodiment;
Fig. 23 is an external perspective view showing one battery module used in a battery system according to a tenth embodiment;
Fig. 24 is a view showing one side surface of the battery module of Fig. 23;
Fig. 25 is a view showing the other side surface of the battery module of Fig. 23;
Fig. 26 is an external perspective view showing the other battery module used in the battery system according to the tenth embodiment;
Fig. 27 is an external perspective view showing the arrangement of a module group included in the battery system according to the tenth embodiment;
Fig. 28 is a block diagram showing the configuration of an electric automobile including the battery system of Fig. 1.

### [1] First Embodiment

Hereinafter, description will be made of a battery system according to a first embodiment while referring to the drawings. Note that the battery system according to the present embodiment is mounted on an electric vehicle (an electric automobile, for example) using electric power as a driving source.

### (1) Configuration of the Battery System

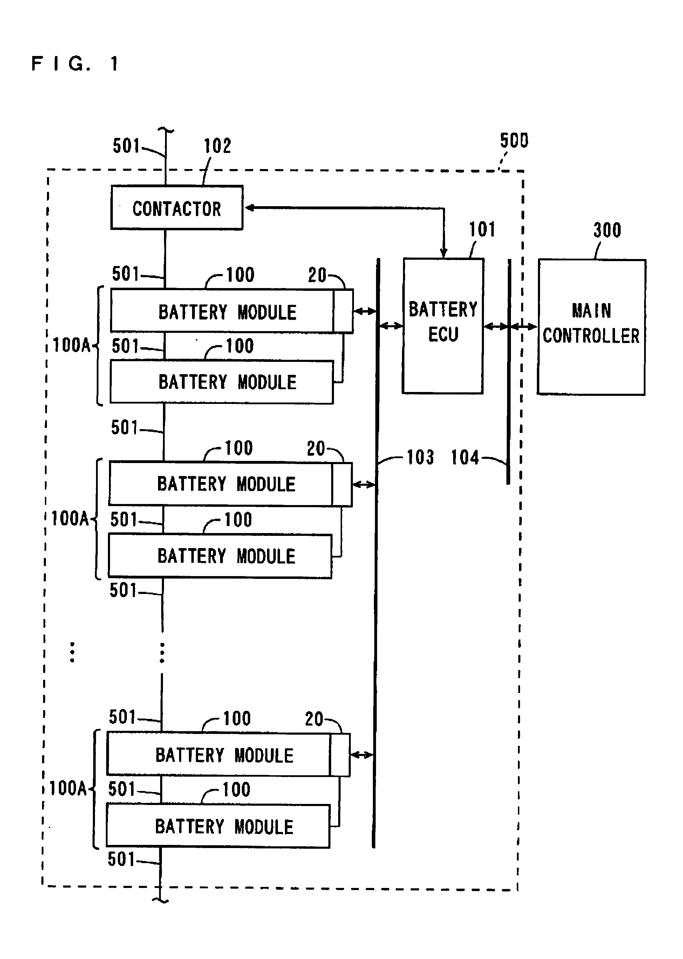

Fig. 1 is a block diagram showing the schematic configuration of the battery system according to the first embodiment. As shown in Fig. 1, main constituents of the battery system 500 are a plurality of battery modules 100, a plurality of detecting circuits 20, a battery ECU (Electronic Control Unit) 101 and a contactor 102, and the battery system 500 is connected to a main controller 300 of the electric vehicle via a bus 104. The battery system 500 includes a casing that is not shown. The components of the battery system 500 are housed in the casing.

The plurality of battery modules 100 of the battery system 500 are connected to one another through power supply lines 501. One detecting circuit 20 is provided in common for two battery modules 100. Each detecting circuit 20 is used in common for two battery modules 100. Details will be described below.

In the following description, a configuration mainly composed of the two battery modules 100, and the detecting circuit 20 that is used in common for the two battery modules 100 is referred to as a module group 100A.

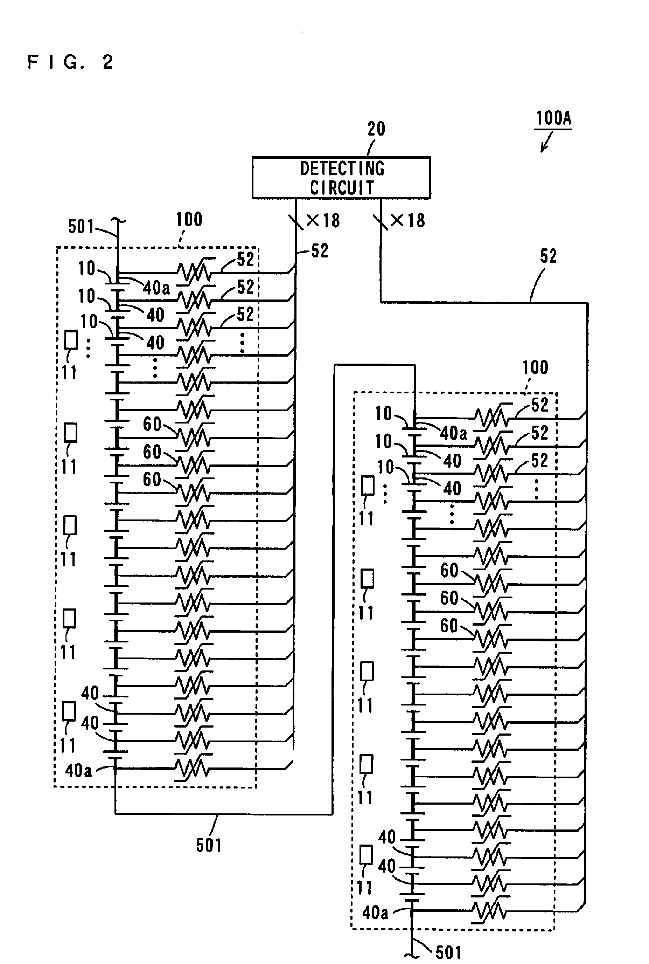

Fig. 2 is a block diagram showing the configuration of the module group 100A of Fig. 1. As shown in Fig. 2, the two battery modules 100 of the module group 100A are connected to each other through the power supply line 501. Each battery module 100 includes a plurality of (eighteen in this example) battery cells 10 and a plurality of (five in this example) thermistors 11.

In each battery module 100, the plurality of battery cells 10 are integrally arranged so as to be adjacent to one another, and are connected in series through a plurality of bus bars 40. Each battery cell 10 is a secondary battery such as a lithium-ion battery or a nickel metal hydride battery.

The battery cells 10 arranged at both ends of the battery module 100 are connected to the power supply lines 501 through bus bars 40a, respectively. In this manner, all the battery cells 10 of the plurality of battery modules 100 are connected in series in the battery system 500. The power supply lines 501 pulled out from the battery system 500 are connected to a load such as a motor of the electric vehicle.

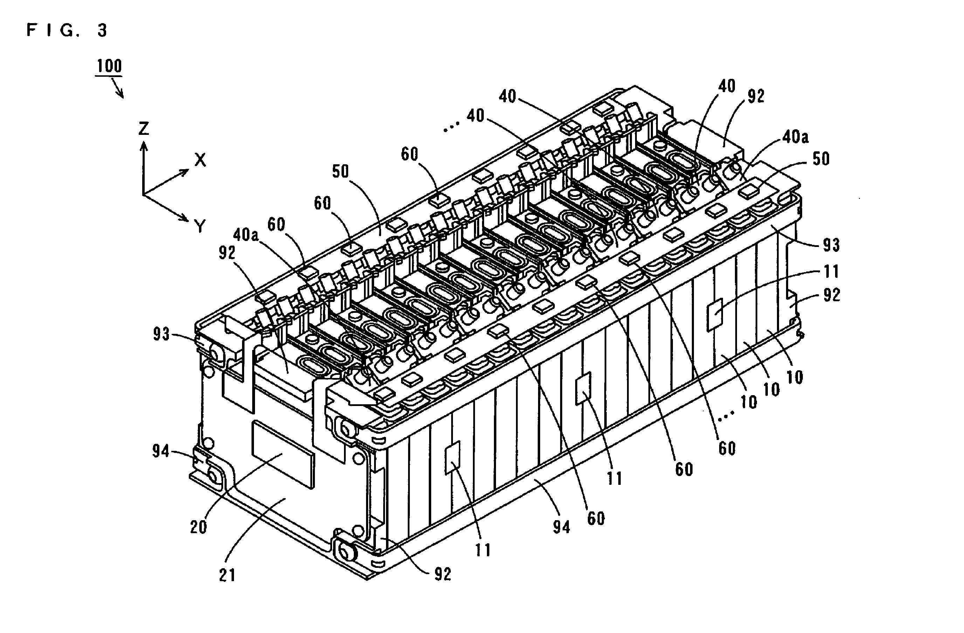

The detecting circuit 20 is attached to one battery module 100 (see Fig. 3, described below) of the two battery modules 100 in the module group 100A.

The detecting circuit 20 is electrically connected to all the bus bars 40, 40a of the two battery modules 100 through conductor lines 52 and PTC (Positive Temperature Coefficient) elements 60. The detecting circuit 20 is electrically connected to all the thermistors 11 of the two battery modules 100.

In the present embodiment, the detecting circuit 20 detects a voltage between terminals of each battery cell 10 by detecting potential differences between the bus bars 40, 40a connecting the plurality of battery cells 10. The detecting circuit 20 functions as a voltage detector. Details will be described below.

Also, the detecting circuit 20 detects a temperature at a given portion of each battery module 100 based on a signal output from the plurality of thermistors 11. The detecting circuit 20 functions as a temperature detector.

In the present embodiment, at least one bus bar 40, 40a of the plurality of bus bars 40, 40a of each battery module 100 is used as a shunt resistance for current detection. The detecting circuit 20 detects a current flowing through each battery module 100 by detecting a voltage at both ends of the bus bar 40, 40a used as the shunt resistance. The detecting circuit 20 functions as a current detector.

The PTC element 60 has such resistance temperature characteristics as to have a resistance value rapidly increasing when its temperature exceeds a certain value. Therefore, if a short occurs in the detecting circuit 20 and the conductor line 52, for example, the temperature of the PTC element 60 that rises because of the current flowing through the short-circuited path causes the resistance value of the PTC element 60 to increase. Accordingly, a large current is inhibited from flowing through the short-circuited path including the PTC element 60.

Returning to Fig. 1, the detecting circuit 20 of the module group 100A is connected to the battery ECU 101 through a bus 103. This causes the voltage, current and temperature detected by the detecting circuit 20 to be given to the battery ECU 101.

The battery ECU 101 calculates the charged capacity of each battery cell 10 based on the voltage, current and temperature given from each detecting circuit 20, for example, and controls charge / discharge of each battery module based on the charged capacity. In addition, the battery ECU 101 detects abnormality of each battery module 100 based on the voltage, current and temperature given from each detecting circuit 20. The abnormality of the battery module 100 includes overdischarge, overcharge or abnormal temperature of the battery cells 10.

While the battery ECU 101 calculates the charged capacity of the battery cell 10 and detects the overdischarge, overcharge or temperature abnormality, for example, of the battery cell 10 in this embodiment, the present invention is not limited to this. The detecting circuit 20 may calculate the charged capacity of the battery cell 10 and detect the overdischarge, overcharge or temperature abnormality, for example, of the battery cell 10, and give the detection results to the battery ECU 101.

The contactor 102 is inserted in the power supply line 501 connected to the battery module 100 at one end of the battery system 500. The battery ECU 101 turns off the contactor 102 when it detects the abnormality of the battery module 100. Since the current does not flow through each battery module 100 in the case of an occurrence of the abnormality, the battery module 100 is prevented from being abnormally heated.

The battery ECU 101 is connected to the main controller 300 through the bus 104. The charged capacity of each battery module 100 (the charged capacity of each battery cell 10 of Fig. 2) is given from the battery ECU 101 to the main controller 300. The main controller 300 controls power of the electric vehicle (a rotational speed of the motor, for example) based on the charged capacity. When the charged capacity of each battery module 100 decreases, the main controller 300 controls a power generating system, not shown, connected to the power supply line 501 to cause each battery module 100 to be charged.

The motor connected to the power supply line 501, for example, functions as the power generating system in this embodiment. In this case, the motor converts electric power supplied from the battery system 500 into power for driving the drive wheel, which is not shown, at the time of acceleration of the electric vehicle. The motor generates regenerated electric power at the time of deceleration of the electric vehicle. Each battery module 100 is charged with the regenerated electric power.

### (2) Details of the Battery Module

Description is made of details of the battery module 100. The foregoing detecting circuit 20 is attached to the battery module 100 described below.

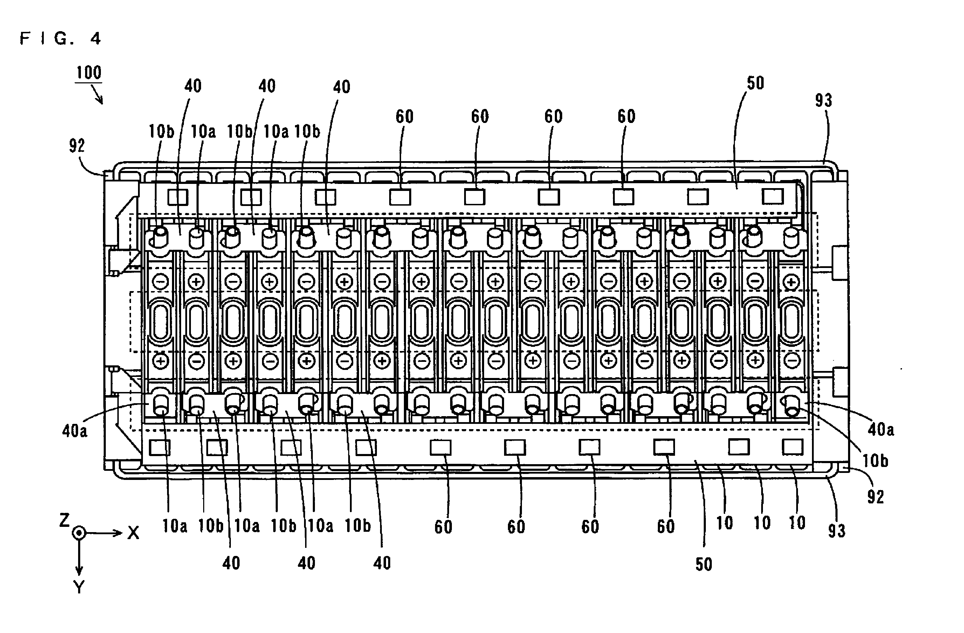

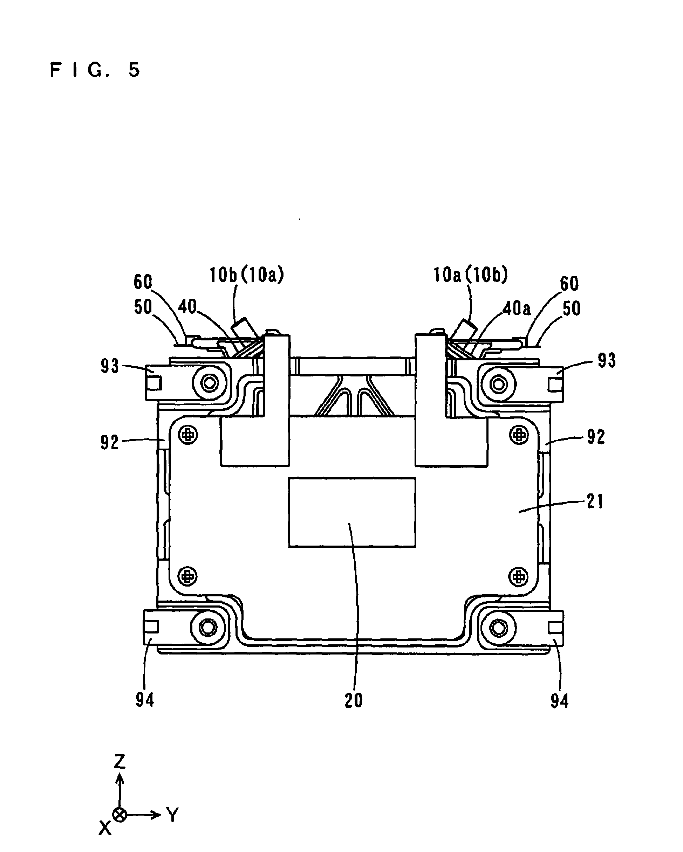

Fig. 3 is an external perspective view of the battery module 100, Fig. 4 is a plan view of the battery module 100, and Fig. 5 is an end view of the battery module 100.

In Figs. 3 to 5 and Figs. 7, 8, 10 to 19, 21 and 23 to 27 described below, three directions that are perpendicular to one another are defined as an X-direction, a Y-direction and a Z-direction as indicated by the arrows X, Y, Z. The X-direction and the Y-direction are parallel to a horizontal plane, and the Z-direction is perpendicular to the horizontal plane in this example.

As shown in Figs. 3 to 5, the plurality of battery cells 10 each having a flat and substantially rectangular parallelepiped shape are arranged to line up in the X direction in the battery module 100. In this state, the plurality of battery cells 10 are integrally fixed by a pair of end surface frames 92, a pair of upper end frames 93 and a pair of lower end frames 94.

Each of the pair of end surface frames 92 has a substantially plate shape, and is arranged parallel to the Y-Z plane. The pair of upper end frames 93 and the pair of lower end frames 94 are arranged to extend in the X-direction.

Connection portions for connecting the pair of upper end frames 93 and the pair of lower end frames 94 thereto are formed at four corners of each of the pair of end surface frames 92. The pair of upper end frames 93 is attached to the upper connection portions of the pair of end surface frames 92, and the pair of lower end frames 94 is attached to the lower connection portions of the pair of end surface frames 92 while the plurality of battery cells 10 are arranged between the pair of end surface frames 92. Accordingly, the plurality of battery cells 10 are integrally fixed while being arranged to line up in the X-direction.

A rigid printed circuit board (hereinafter abbreviated as a printed circuit board) 21 is attached to an outer surface of one end surface frame 92 with a distance therebetween. The detecting circuit 20 is provided on the printed circuit board 21.

Here, the plurality of battery cells 10 each have a plus electrode 10a arranged on an upper surface portion on one end side or the other end side in the Y-direction, and have a minus electrode 10b arranged on an upper surface portion on the opposite side. Each of the electrodes 10a, 10b is provided to be inclined and project upward (see Fig. 5).

In the following description, the battery cell 10 adjacent to the end surface frame 92 to which the printed circuit board 21 is not attached to the battery cell 10 adjacent to the end surface frame 92 to which the printed circuit board 21 is attached are referred to as a first battery cell 10 to an eighteenth battery cell 10.

In the battery module 100, the battery cells 10 are arranged such that the positional relationship between the plus electrode 10a and the minus electrode 10b of each battery cell 10 in the Y-direction is opposite to that of the adjacent battery cell 10, as shown in Fig. 4.

Thus, in two adjacent battery cells 10, the plus electrode 10a of one battery cell 10 is in close proximity to the minus electrode 10b of the other battery cell 10, and the minus electrode 10b of the one battery cel1 10 is in close proximity to the plus electrode 10a of the other battery cell 10. In this state, the bus bar 40 is attached to the two electrodes being in close proximity to each other. This causes the plurality of battery cells 10 to be connected in series.

More specifically, the common bus bar 40 is attached to the plus electrode 10a of the first battery cell 10 and the minus electrode 10b of the second battery cell 10. The common bus bar 40 is attached to the plus electrode 10a of the second battery cell 10 and the minus electrode 10b of the third battery cell 10. Similarly, the common bus bar 40 is attached to the plus electrode 10a of each of the odd numbered battery cells 10 and the minus electrode 10b of each of the even numbered battery cells 10 adjacent thereto. The common bus bar 40 is attached to the plus electrode 10a of each of the even numbered battery cells 10 and the minus electrode 10b of each of the odd numbered battery cells 10 adjacent thereto.

The bus bar 40a for connecting the power supply line 501 from the exterior is attached to each of the minus electrode 10b of the first battery cell 10 and the plus electrode 10a of the eighteenth battery cell 10.

A long-sized flexible printed circuit board (hereinafter abbreviated as an FPC board) 50 extending in the X-direction is connected in common to the plurality of bus bars 40 on the one end side of the plurality of battery cells 10 in the Y-direction. Similarly, a long-sized FPC board 50 extending in the X-direction is connected in common to the plurality of bus bars 40, 40a on the other end side of the plurality of battery cells 10 in the Y-direction.

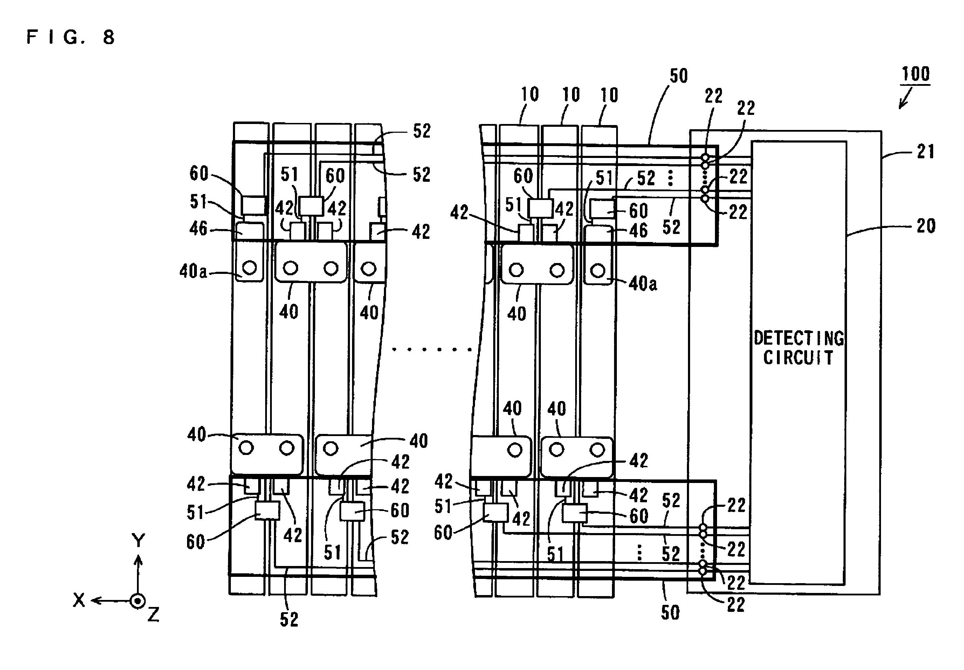

The FPC board 50 having bending characteristics and flexibility mainly includes a plurality of conductor lines (wiring traces) 51, 52 (see Fig. 8, described below) formed on an insulating layer. Examples of the material for the insulating layer constituting the FPC board 50 include polyimide, and examples of the material for the conductor lines 51, 52 (see Fig. 8, described below) include copper. The PTC elements 60 are arranged close to the bus bars 40, 40a, respectively, on the FPC board 50.

Each FPC board 50 is bent inward at a right angle and further bent downward at an upper end portion of the end surface frame 92 (the end surface frame 92 to which the printed circuit board 21 is attached) to be connected to the printed circuit board 21.

Two FPC boards 50 of the battery module 100 to which the detecting circuit 20 is not attached are connected to the printed circuit board 21 attached to the other battery module 100 of the same module group 100A.

### (3) The Configurations of the Bus Bars and the FPC Boards

Next, description is made of details of the configurations of the bus bars 40, 40a and the FPC boards 50. In the following paragraphs, the bus bar 40 for connecting the plus electrode 10a and the minus electrode 10b of two adjacent battery cells 10 is referred to as the bus bar for two electrodes 40, and the bus bar 40a for connecting the plus electrode 10a or the minus electrode 10b of one battery cell 10 and the power supply line 501 is referred to as the bus bar for one electrode 40a.

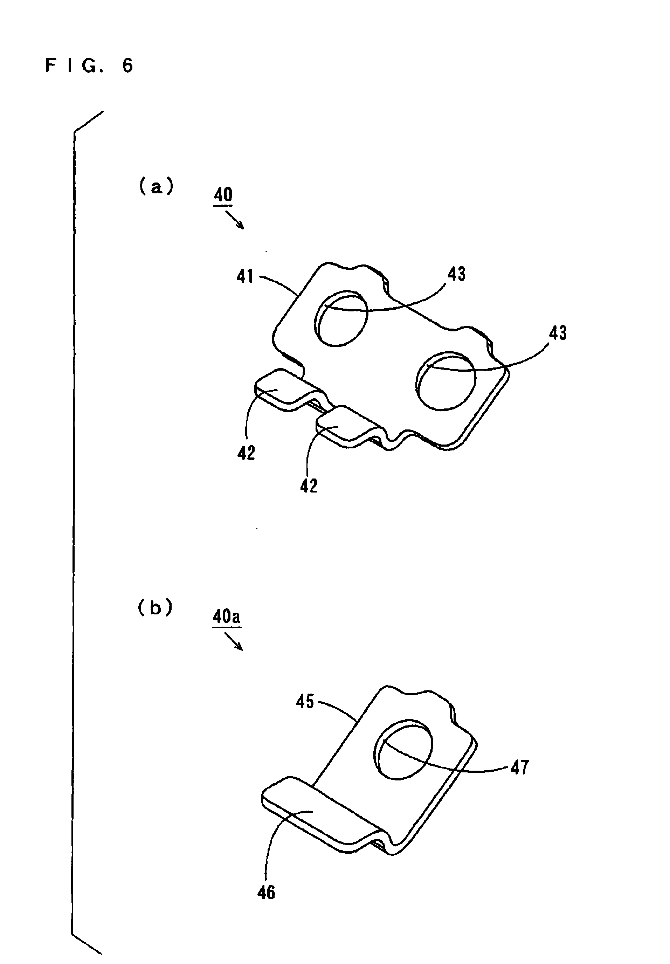

Fig. 6 (a) is an external perspective view of the bus bar for two electrodes 40, and Fig. 6(b) is an external perspective view of the bus bar for one electrode 40a.

As shown in Fig. 6 (a), the bus bar for two electrodes 40 includes a base portion 41 having a substantially rectangular shape and a pair of attachment portions 42 that is bent and extends toward one surface side from one side of the base portion 41. A pair of electrode connection holes 43 is formed in the base portion 41.

As shown in Fig. 6 (b), the bus bar for one electrode 40a includes a base portion 45 having a substantially square shape and an attachment portion 46 that is bent and extends toward one surface side from one side of the base portion 45. An electrode connection hole 47 is formed in the base portion 45.

In the present embodiment, the bus bars 40, 40a are each composed of tough pitch copper having a nickel-plated surface, for example.

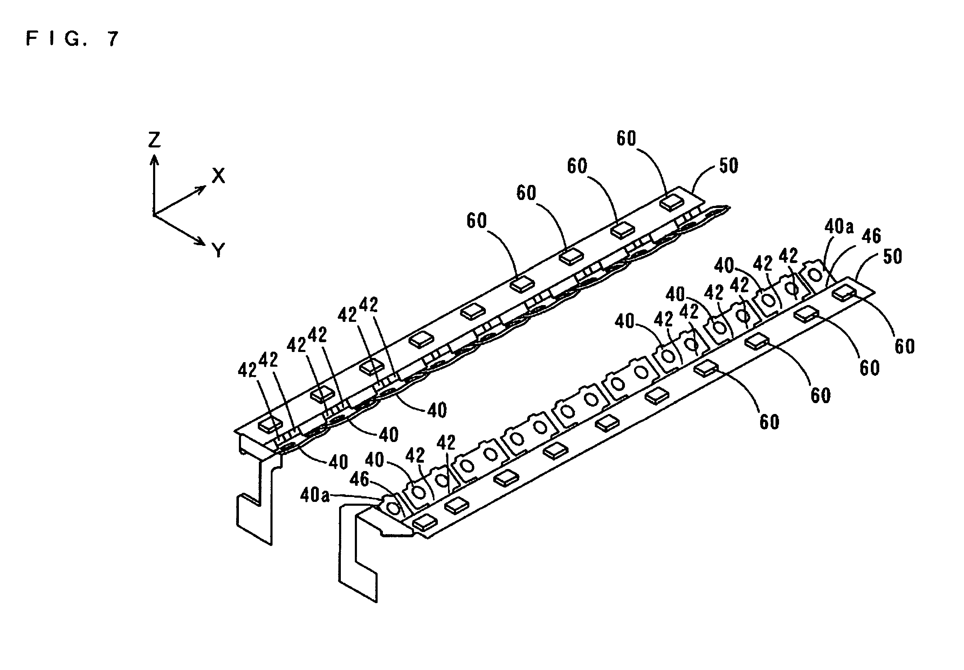

Fig. 7 is an external perspective view of the FPC boards 50 to which the plurality of bus bars 40, 40a and the plurality of PTC elements 60 are attached. As shown in Fig. 7, the attachment portions 42, 46 of the plurality of bus bars 40, 40a are attached to the two FPC boards 50 at given spacings along the X-direction. The plurality of PTC elements 60 are attached to the two FPC boards 50 at the same spacings as the spacings between the plurality of bus bars 40, 40a.

The two FPC boards 50 each having the plurality of bus bars 40, 40a and the plurality of PTC elements 60 attached thereto in the foregoing manner are attached to the plurality of battery cells 10 that are integrally fixed by the end surface frames 92 (see Fig. 3), the upper end frames 93 (see Fig. 3) and the lower end frames 94 (see Fig. 3) during the manufacture of the battery module 100.

During the mounting, the plus electrode 10a and the minus electrode 10b of the adjacent battery cells 10 are fitted in the electrode connection holes 43, 47 formed in each bus bar 40, 40a. A male thread is formed at each of the plus electrodes 10a and the minus electrodes 10b. With each of the bus bars 40, 40a fitted with the plus electrode 10a and minus electrode 10b of the adjacent battery cells 10, the male threads of the plus electrodes 10a and the minus electrodes 10b are screwed in nuts (not shown).

In this manner, the plurality of bus bars 40, 40a are attached to the plurality of battery cells 10 while the FPC boards 50 are held in a substantially horizontal attitude by the plurality of bus bars 40, 40a.

### (4) Connection between the Bus Bars and the Detecting Circuit

Description is made of connection between the bus bars 40, 40a and the detecting circuit 20. Fig. 8 is a schematic plan view for explaining connection between the bus bars 40, 40a and the detecting circuit 20. In this example, description is made of connection between the bus bars 40, 40a and the detecting circuit 20 in the battery module 100 to which the detecting circuit 20 is attached.

As illustrated in Fig. 8, each FPC board 50 is provided with the plurality of conductor lines 51, 52 that correspond to the plurality of bus bars 40, 40a, respectively. Each conductor line 51 is provided to extend parallel to the Y-direction between the attachment portion 42, 46 in the bus bar 40, 40a and the PTC element 60 arranged in the vicinity of the bus bar 40. Each conductor line 52 is provided to extend parallel to the X-direction between the PTC element 60 and one end of the FPC board 50.

One end of each conductor line 51 is provided to be exposed on the lower surface of the FPC board 50. The one end of each conductor line 51 exposed on the lower surface is electrically connected to the attachment portion 42, 46 in the bus bar 40, 40a by soldering or welding, for example. Accordingly, the FPC board 50 is fixed to each of the bus bars 40, 40a.

The other end of each conductor line 51 and one end of each conductor line 52 are provided to be exposed on the upper surface of the FPC board 50. A pair of terminals (not illustrated) of the PTC element 60 is connected to the other end of each conductor line 51 and one end of each conductor line 52 by soldering, for example.

Each of the PTC elements 60 is preferably arranged in a region between both ends in the X-direction of the corresponding bus bar 40, 40a. When stress is applied to the FPC board 50, a region of the FPC board 50 between the adjacent bus bars 40, 40a is easily deflected. However, the region of the FPC board 50 between both the ends of each of the bus bars 40, 40a is kept relatively flat because it is fixed to the bus bar 40, 40a. Therefore, each of the PTC elements 60 is arranged within the region of the FPC board 50 between both the ends of each of the bus bars 40, 40a so that connection characteristics between the PTC element 60 and the conductor lines 51, 52 are sufficiently ensured. Moreover, the effect of deflection of the FPC board 50 on each of the PTC elements 60 (e.g., a change in the resistance value of the PTC element 60) is suppressed.

A plurality of connection terminals 22 corresponding to the plurality of conductor lines 52, respectively, of the FPC boards 50 are provided in the printed circuit board 21. The other ends of the conductor lines 52 of the FPC boards 50 are connected to the corresponding connection terminals 22 by soldering or welding, for example. The printed circuit board 21 and the FPC boards 50 may not be connected by soldering or welding. For example, connecters may be used for connecting the printed circuit board 21 and the FPC boards 50.

In this manner, each of the bus bars 40, 40a is electrically connected to the detecting circuit 20 via the PTC element 60.

### (5) Example of the Configuration of the Detecting Circuit

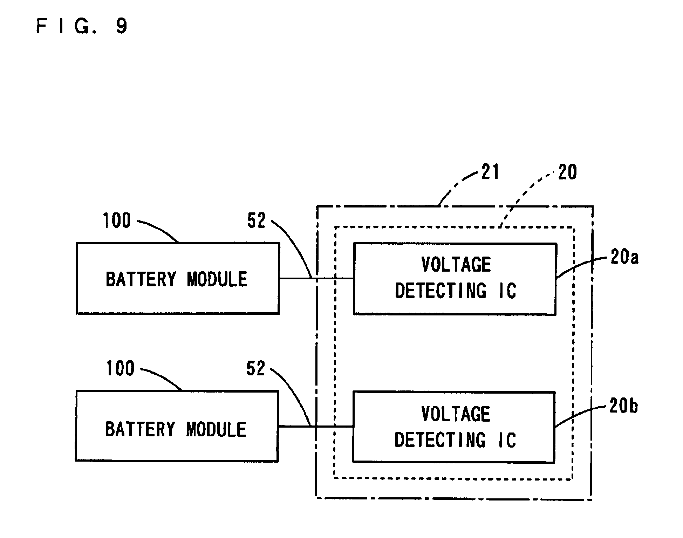

Fig. 9 is a block diagram showing an example of the configuration of the detecting circuit 20. The detecting circuit 20 shown in Fig. 9 includes first and second voltage detecting ICs (Integrated Circuits) 20a, 20b. The first voltage detecting IC 20a is provided corresponding to one battery module 100 of the module group 100A (see Fig. 2), and the second voltage detecting IC 20b is provided corresponding to the other battery module 100 in this example. The first and second voltage detecting ICs 20a, 20b are mounted on one printed circuit board 21.

The plurality of bus bars 40, 40a (see Fig. 2) of the one battery module 100 and the first voltage detecting IC 20a are connected through the plurality of conductor lines 52. The plurality of bus bars 40, 40a (see Fig. 2) of the other battery module 100 and the second voltage detecting IC 20b are connected through the plurality of conductor lines 52. Accordingly, the terminal voltage of each battery cell 10 (see Fig. 2) in the two battery modules 100 is detected.

In Fig. 9, the plurality of conductor lines 52 connecting the plurality of bus bars 40, 40a of the one battery module 100 and the first voltage detecting IC 20a are indicated by one line. Similarly, the plurality of conductor lines 52 connecting the plurality of bus bars 40, 40a of the other battery module 100 and the second voltage detecting IC 20b are indicated by one line.

A plurality of (two or three, for example) voltage detecting ICs corresponding to one battery module 100 may be mounted on one printed circuit board 21 instead of the foregoing first and second voltage detecting ICs 20a, 20b. In this case, each voltage detecting IC detects the respective terminal voltages of the previously assigned battery cells 10.

One voltage detecting IC corresponding to two battery modules 100 of the module group 100A may be mounted on one printed circuit board 21 instead of the foregoing first and second voltage detecting ICs 20a, 20b. In this case, the respective terminal voltages of all the battery cells 10 (see Fig. 2) in the module group 100A are detected by the one voltage detecting IC.

### (6) Arrangement of the Components in the Module Group

As described above, the module group 100A of Fig. 1 is mainly composed of the two battery modules 100 and the detecting circuit 20 used in common for the two battery modules 100. The detecting circuit 20 is attached to the one battery module 100 in the module group 100A (see Figs. 2, 3 and 5). Description is made of the arrangement of the components.

In the following description, the one battery module 100 is referred to as a battery module 100a, and the other battery module 100 is referred to as a battery module 100b in order to distinguish the two battery modules 100. The FPC boards 50 of the battery module 100a are referred to as FPC boards 50a, and the FPC boards 50 of the battery module 100b are referred to as FPC boards 50b. Also in second to tenth embodiments described below, each battery module 100 and each FPC board 50 is denoted with a different character when one module group includes a plurality of battery modules 100.

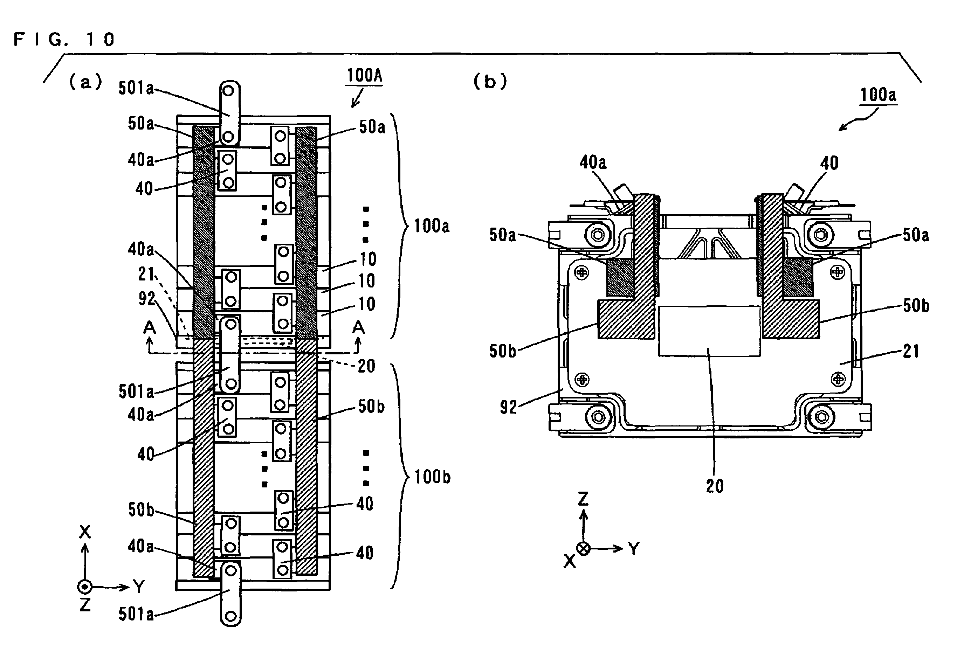

Fig. 10 (a) is a plan view showing the arrangement of the module group 100A, and Fig. 10(b) is an end view of the one battery module 100a that is seen from the line A-A of Fig. 10 (a). In Figs. 10 (a) and (b), the FPC boards 50a, 50b of the respective battery modules 100a, 100b are indicated by different types of hatching.

As shown in Fig. 10 (a), the two battery modules 100a, 100b are arranged to line up along the X-direction (the direction in which the plurality of battery cells 10 line up) in this example.

Between the two battery modules 100a, 100b, two bus bars 40a provided at respective ends, which are in close proximity to each other, of the two battery modules 100a, 100b are connected by a strip-shaped bus bar 501a. Thus, all the battery cells 10 of the two battery modules 100a, 100b are connected in series. The bus bar 501a in this example corresponds to the power supply line 501 of Figs. 1 and 2. Fig. 10 (b) does not show the bus bar 501 a.

As shown in Fig. 10 (a), the printed circuit board 21 including the detecting circuit 20 is attached to an end surface of the one battery module 100a and positioned between end surfaces, which are in close proximity to each other, of the two battery modules 100a, 100b. The printed circuit board 21 is fixed by the above-mentioned end surface frames 92 in this example.

As shown in Fig. 10 (b), ends of the two FPC boards 50a of the one battery module 100a are connected to a portion in the vicinity of an upper end of the printed circuit board 21 in this example. Ends of the two FPC boards 50b of the other battery module 100b are connected to a portion at substantially the center of the printed circuit board 21.

In this manner, the two FPC boards 50a, 50b of the battery modules 100a, 100b are connected to the common printed circuit board 21, and the plurality of bus bars 40, 40a of the two battery modules 100a, 100b are electrically connected to the detecting circuit 20. Details of connection between each of the FPC boards 50a, 50b and the printed circuit board 21 are described above. Accordingly, the detecting circuit 20 is used in common for the two battery modules 100a, 100b.

Since the detecting circuit 20 need not be provided for each of the battery modules 100a, 100b, the simplified configuration and reduced cost of the battery system 500 of Fig. 1 are realized.

The smaller number of the detecting circuits 20 that communicate with the battery ECU 101 of Fig. 1 causes the wiring for communication to be simplified. Accordingly, reduced cost, easier assembly and improved reliability of the entire battery system 500 are realized.

As described above, the common detecting circuit 20 is arranged between the two battery modules 100a, 100b according to the present embodiment. Thus, the length of each of the FPC boards 50a, 50b (the conductor lines 52) connecting the battery modules 100a, 100b and the detecting circuit 20 can be reduced as compared with a case where the detecting circuit 20 is attached to an outer end surface of either one of the two battery modules 100a, 100b. The printed circuit board 21 including the detecting circuit 20 is integrated with the one battery module 100a of the module group 100A in the present embodiment. This allows for easier assembly of the battery system 500.

In the present embodiment, a gap functioning as a path for gas (air, for example) is preferably provided between the two battery modules 100a, 100b. In this case, gas passing through the gap causes heat generated in the detecting circuit 20 to be dissipated.

### (7) Assembly of the Battery System

As described above, the battery system 500 according to the present embodiment includes the casing (hereinafter referred to as a system casing) that is not shown. The plurality of battery modules 100 are fixed within the system casing during the assembly of the battery system 500.

Each battery module 100 may be attached to the system casing after being completed. In this case, the two FPC boards 50 have already been attached to the plurality of battery cells 10 when each battery module 100 is attached to the system casing.

In contrast, the battery modules 100 may be completed within the system casing by attaching the plurality of battery cells 10 integrally fixed by the end surface frames 92 (see Fig. 3), the upper end frames 93 (see Fig. 3) and the lower end frames 94 (see Fig. 3) to the system casing, and then attaching the two FPC boards 50 to the plurality of battery cells 10. When the printed circuit board 21 including the detecting circuit 20 is fixed to an end surface of the battery module 100, the two FPC boards 50 may be attached to the battery module 100 before the battery module 100 is attached to the system casing.

### [2] Second Embodiment

Description will be made of a battery system according to a second embodiment while referring to differences from the battery system 500 according to the first embodiment.

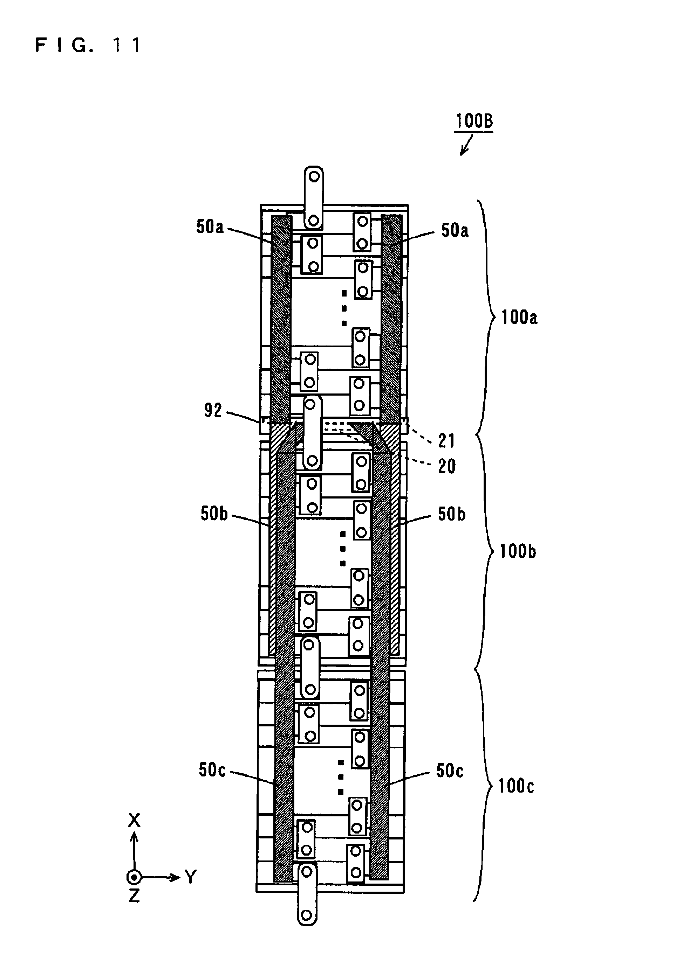

Fig. 11 is a plan view showing the arrangement of a module group included in the battery system according to the second embodiment.

As shown in Fig. 11, a module group 100B includes three battery modules 100a, 100b, 100c in the battery system according to the present embodiment. One detecting circuit 20 is provided in common for the three battery modules 100a, 100b, 100c.

In the present embodiment, the three battery modules 100c, 100b, 100a are arranged to line up in this order along the X-direction (the direction in which the plurality of battery cells 10 line up).

The printed circuit board 21 including the detecting circuit 20 is attached to an end surface of the one battery module 100a and positioned between end surfaces, which are in close proximity to each other, of the battery modules 100a, 100b. Also in this example, the printed circuit board 21 is fixed by the above-mentioned end surface frames 92.

In this state, ends of two FPC boards 50a of the one battery module 100a are connected to the printed circuit board 21. Ends of two FPC boards 50b of the other battery module 100b are connected to the printed circuit board 21.

The length of each of FPC boards 50c of the battery module 100c is approximately twice the length of each of the FPC boards 50a, 50b of the battery modules 100a, 100b. The two FPC boards 50c of the battery module 100c extend in the X-direction on an upper surface of the battery module 100c, and further extend in the X-direction to overlap the FPC boards 50b, respectively, on an upper surface of the battery module 100b to be connected to the common printed circuit board 21.

In this manner, the respective two FPC boards 50a, 50b, 50c of the battery modules 100a, 100b, 100c are connected to the common printed circuit board 21. Accordingly, the detecting circuit 20 is used in common for the three battery modules 100a, 100b, 100c. This further reduces the number of the detecting circuits 20 as compared with that in the battery system 500 according to the first embodiment. This results in further simplified configuration and further reduced cost of the battery system. The number of the detecting circuits 20 that communicate with the battery ECU 101 of Fig. 1 is reduced, thereby simplifying the wiring for communication. Accordingly, reduced cost, easier assembly and improved reliability of the entire battery system 500 are realized.

### [3] Third Embodiment

Description will be made of a battery system according to a third embodiment while referring to differences from the battery system 500 according to the first embodiment.

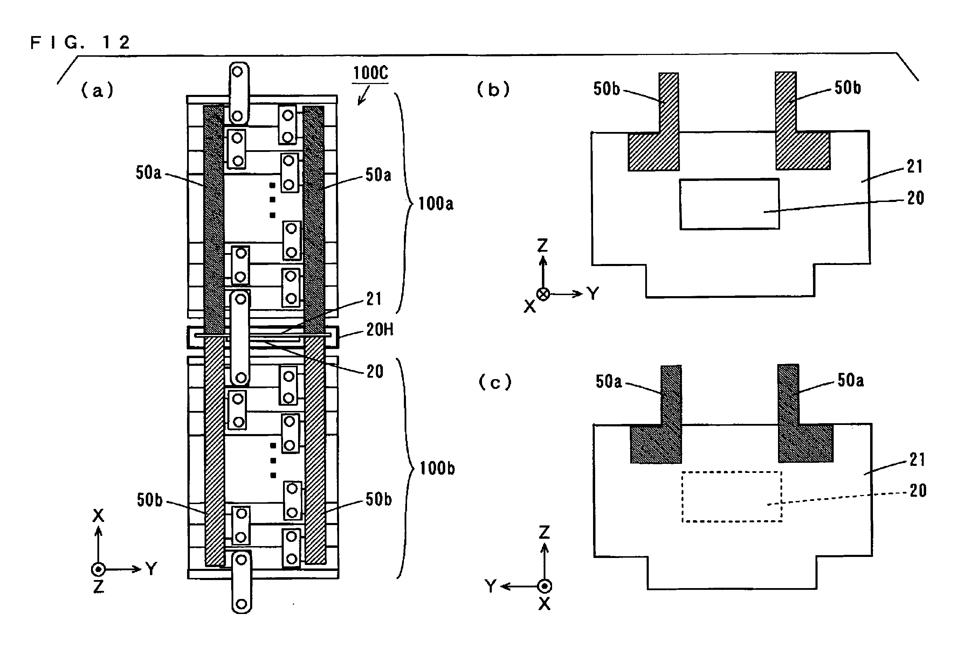

Fig. 12 (a) is a plan view showing the arrangement of a module group in the battery system according to the third embodiment, Fig. 12 (b) is a diagram showing one surface of the printed circuit board 21 of Fig. 12 (a), and Fig. 12 (c) is a diagram showing the other surface of the printed circuit board 21 of Fig. 12 (a).

In the battery system according to the present embodiment, the module group 100C includes two battery modules 100a, 100b as shown in Fig. 12 (a). Similarly to the battery system 500 according to the first embodiment, the one detecting circuit 20 is provided in common for the two battery modules 100a, 100b.

As shown in Fig. 12 (a), the two battery modules 100a, 100b are arranged to line up along the X-direction (the direction in which the plurality of battery cells 10 line up) in the present embodiment. The printed circuit board 21 including the detecting circuit 20 is held by a holder 20H and positioned between end surfaces, which are in close proximity to each other, of the battery modules 100a, 100b. The printed circuit board 21 is held by the holder 20H such that its one surface and the other surface are exposed to the outside in the present embodiment.

As shown in Fig. 12 (b), ends of the two FPC boards 50b of the battery module 100b are connected to a portion in the vicinity of an upper end of the one surface of the printed circuit board 21 in the present embodiment. As shown in Fig. 12 (c), ends of the two FPC boards 50a of the battery module 100a are connected to a portion in the vicinity of an upper end of the other surface of the printed circuit board 21.

In this manner, the two FPC boards 50a, 50b of the battery modules 100a, 100b are connected to the common printed circuit board 21. Accordingly, the detecting circuit 20 is used in common for the two battery modules 100a, 100b.

In the present embodiment, the ends of the plurality of FPC boards 50a, 50b are connected to the both surfaces of the printed circuit board 21, respectively. This enlarges a region in the printed circuit board 21 on which electronic components are to be mounted.

While the ends of the plurality of FPC boards 50a, 50b are connected to the both surfaces of the printed circuit board 21 in the present embodiment, the present invention is not limited to this. The ends of the plurality of FPC boards 50a, 50b may be connected to either one of the one surface and the other surface of the printed circuit board 21.

In this case, terminals can be easily formed, so that reduced cost of the printed circuit board 21 is realized. In addition, the plurality of FPC boards 50a, 50b can be connected to the one surface or the other surface of the printed circuit board 21, thus facilitating connection operation such as soldering or welding. This results in reduced manufacturing cost of the battery system.

### [4] Fourth Embodiment

Description will be made of a battery system according to a fourth embodiment while referring to differences from the battery system 500 according to the first embodiment.

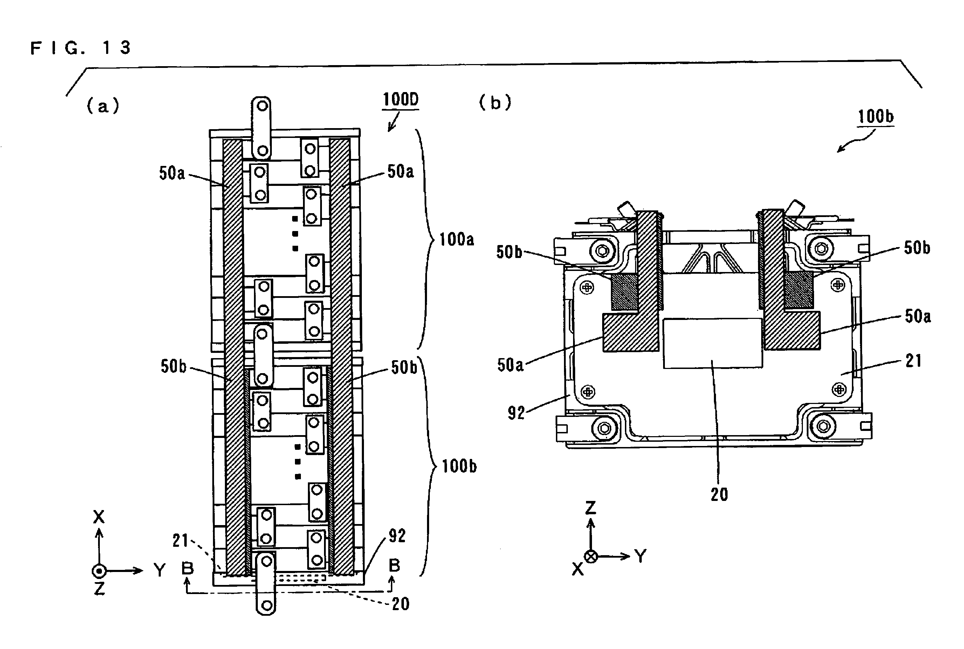

Fig. 13 (a) is a plan view showing the arrangement of a module group in the battery system according to the fourth embodiment, and Fig. 13 (b) is an end view of one battery module 100b that is seen from the line B-B of Fig. 13 (a).

As shown in Fig. 13 (a), the module group 100D includes two battery modules 100a, 100b. Similarly to the battery system 500 according to the first embodiment, the two battery modules 100a, 100b are arranged to line up along the X-direction (the direction in which the plurality of battery cells 10 line up). The one detecting circuit 20 is provided in common for the two battery modules 100a, 100b.

In the battery system according to the present embodiment, the printed circuit board 21 including the detecting circuit 20 is attached to an outer end surface of the battery module 100b. In this state, ends of the two FPC boards 50b of the battery module 100b are connected to the printed circuit board 21. Also in this example, the printed circuit board 21 is fixed by the above-mentioned end surface frames 92.

The length of each of the FPC boards 50a of the battery module 100a is approximately twice the length of each of the FPC boards 50b of the battery module 100b. The two FPC boards 50a of the battery module 100a extend in the X-direction on an upper surface of the battery module 100a, and further extend in the X-direction to overlap the FPC boards 50b, respectively, on an upper surface of the battery module 100b to be connected to the common printed circuit board 21.

In this manner, the respective two FPC boards 50a, 50b, of the battery modules 100a, 100b are connected to the common printed circuit board 21. Accordingly, the detecting circuit 20 is used in common for the two battery modules 100a, 100b.

In the battery system according to the present embodiment, the printed circuit board 21 including the detecting circuit 20 is attached to the outer end surface of the battery module 100b of the module group 100D. This improves heat dissipation characteristics of the detecting circuit 20 as compared with that in the battery system 500 according to the first embodiment.

The printed circuit board 21 including the detecting circuit 20 may be attached to an outer end surface of either one of the two battery modules 100a, 100b using the holder 20H described in the third embodiment. Also in this case, the same effects can be obtained.

The printed circuit board 21 including the detecting circuit 20 may be attached to an outer end surface of the battery module 100a, or may be attached to either one of a pair of side surfaces, which are perpendicular to the Y-direction, of the battery module 100b, or may be attached to either one of a pair of side surfaces, which are perpendicular to the Y-direction, of the battery module 100a, instead of being attached to the outer end surface of the battery module 100b. Also in these cases, the same effects can be obtained. As described above, the printed circuit board 21 including the detecting circuit 20 may be provided on any of the outer peripheral surfaces of the module group 100D in which the two battery modules 100a, 100b are integrally arranged.

### [5] Fifth Embodiment

Description will be made of a battery system according to a fifth embodiment while referring to differences from the battery system 500 according to the first embodiment.

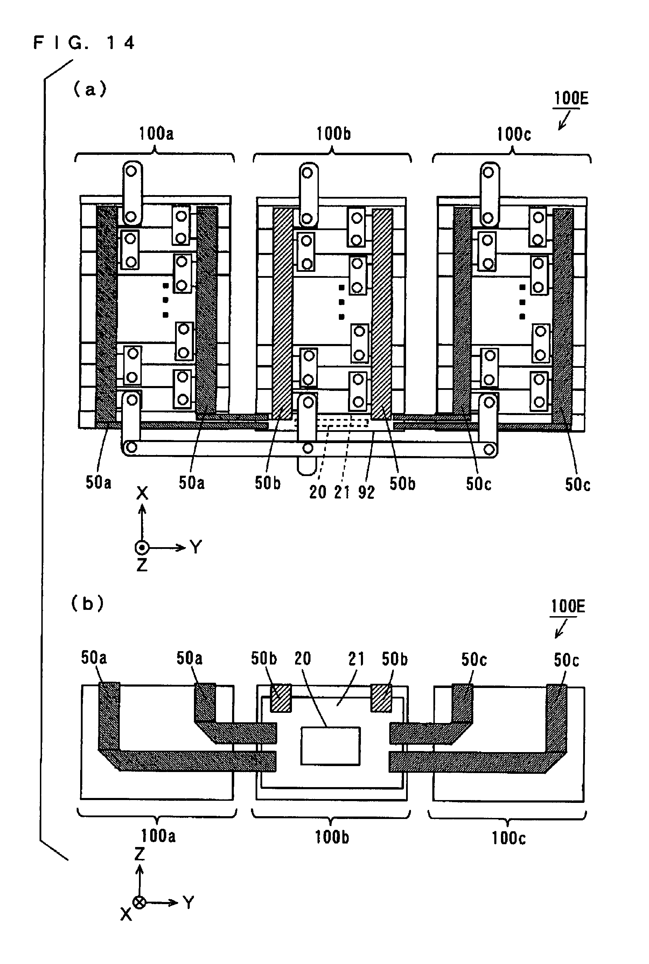

Fig. 14 (a) is a plan view showing the arrangement of a module group in the battery system according to the fifth embodiment, and Fig. 14 (b) is an end view of the module group of Fig. 14 (a) that is seen from the side of its one end surface.

As shown in Fig. 14 (a), the module group 100E includes three battery modules 100a, 100b, 100c in the battery system according to the present embodiment. One detecting circuit 20 is provided in common for the three battery modules 100a, 100b, 100c.

In the present embodiment, each of the three battery modules 100c, 100b, 100a is positioned along the X-direction (the direction in which the plurality of battery cells 10 line up) while being arranged parallel to one another. The three battery modules 100a, 100b, 100c line up in this order in the Y-direction (a direction perpendicular to the direction in which the plurality of battery cells 10 line up).

As shown in Figs. 14 (a) and (b), the printed circuit board 21 including the detecting circuit 20 is attached to one end surface of the battery module 100b positioned in the center. In this state, ends of two FPC boards 50b of the battery module 100b are connected to the printed circuit board 21. Also in this example, the printed circuit board 21 is fixed by the above-mentioned end surface frames 92.

FPC boards 50a of the battery module 100a extend in the X-direction on an upper surface of the battery module 100a, further extend in the Y-direction along one end surface of the battery module 100a to be connected to one end in the Y-direction of the common printed circuit board 21.

FPC boards 50c of the battery module 100c extend in the X-direction on an upper surface of the battery module 100c, and further extend in the Y-direction along one end surface of the battery module 100c to be connected to the other end in the Y-direction of the common printed circuit board 21.

In this manner, the respective two FPC boards 50a, 50b, 50c of the battery modules 100a, 100b, 100c are connected to the common printed circuit board 21. Accordingly, similarly to the second embodiment, the detecting circuit 20 is used in common for the three battery modules 100a, 100b, 100c. This further reduces the number of the detecting circuits 20 as compared with that in the battery system 500 according to the first embodiment. This results in further simplified configuration and further reduced cost of the battery system. The number of the detecting circuits 20 that communicate with the battery ECU 101 of Fig. 1 is reduced, thereby simplifying the wiring for communication. Thus, reduced cost, easier assembly and improved reliability of the entire battery system 500 are realized.

### [6] Sixth Embodiment

Description will be made of a battery system according to a sixth embodiment while referring to differences from the battery system 500 according to the first embodiment.

### (1) Entire Configuration of Battery System

The battery system according to the sixth embodiment includes two module groups, and each module group includes two battery modules. In the present embodiment, one module group is referred to as a module group 110A, and the other module group is referred to as a module group 110B in order to distinguish the two module groups.

In the module group 110A, one battery module is referred to as a battery module 110a, and the other battery module is referred to as a battery module 110b. In the module group 110B, one battery module is referred to as a battery module 110c, and the other battery module is referred to as a battery module 110d.

The configuration of each of the battery modules 110a to 110d is substantially the same as the configuration of the battery module 100 of Fig. 3. Details of each of the battery modules 110a to 110d will be described below.

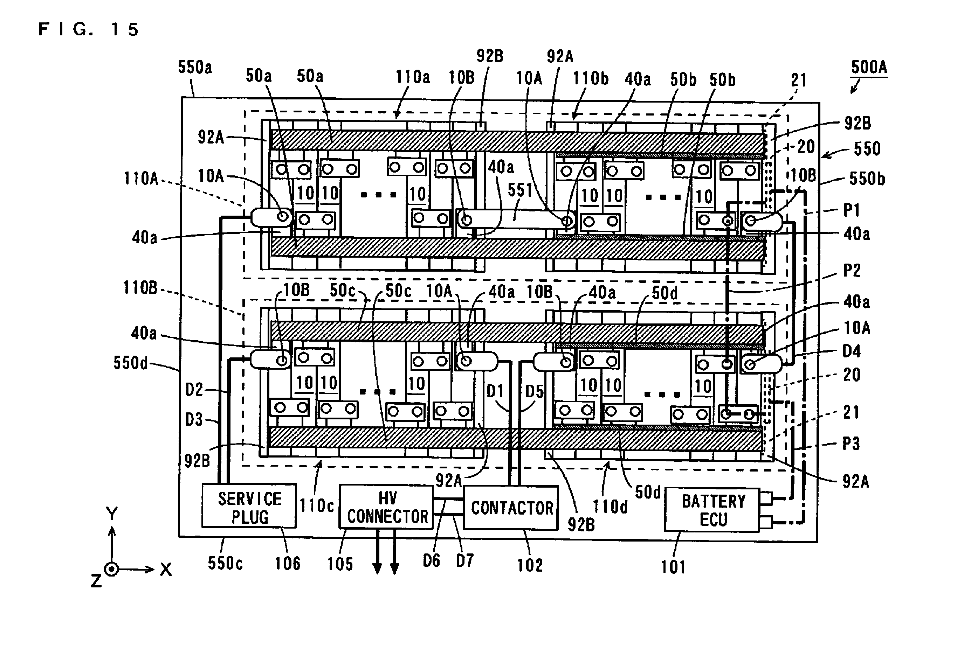

Fig. 15 is a schematic plan view of the battery system according to the sixth embodiment. As shown in Fig. 15, the battery system 500A according to the sixth embodiment includes the module groups 110A, 110B, the battery ECU 101, the contactor 102, an HV (High Voltage) connector 105 and a service plug 106. As described above, the module group 110A includes the two battery modules 110a, 110b, and the module group 110B includes the two battery modules 110c, 110d.

The module groups 110A, 110B, the battery ECU 101, the contactor 102, the HV connector 105 and the service plug 106 are housed in a box-shaped casing 550.

The casing 550 has side surface portions 550a, 550b, 550c, 550d. The side surface portions 550a, 550c are parallel to each other. The side surface portions 550b, 550d are parallel to each other and perpendicular to the side surface portions 550a, 550c.

Within the casing 550, the two battery modules 110b, 110a of the module group 110A are arranged to line up in this order in the X-direction (the direction in which the plurality of battery cells 10 line up) from the side surface portion 550b toward the side surface portion 550d.

Similarly, the two battery modules 110d, 110c of the module group 110B are arranged to line up in this order in the X-direction from the side surface portion 550b toward the side surface portion 550d.

In the Y-direction (the direction perpendicular to the direction in which the plurality of battery cells 10 line up), the module group 110A is positioned on the side of the side surface portion 550a and the module group 110B is positioned on the side of the side surface portion 550c.

The battery ECU 101, the contactor 102, the HV connector 105 and the service plug 106 are arranged to line up in this order in the X-direction from the side surface portion 550b toward the side surface portion 550d in a portion between the module group 110B and the side surface portion 550c.

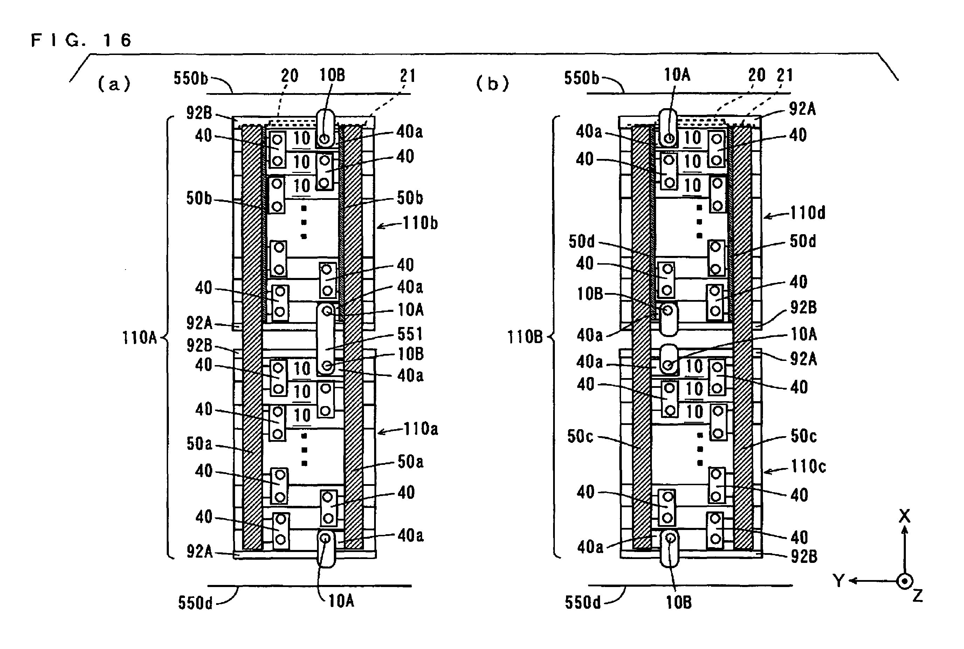

Fig. 16 is a diagram for explaining the details of the module groups 110A, 110B of Fig. 15. Fig. 16 (a) shows an enlarged plan view of the module group 110A of Fig. 15, and Fig. 16(b) shows an enlarged plan view of the module group 110B of Fig. 15.

In the following description, a plus electrode 10a having the highest potential in each of the battery modules 110a to 110d is referred to as a high potential electrode 10A, and a minus electrode 10b having the lowest potential in each of the battery modules 110a to 110d is referred to as a low potential electrode 10B. In this case, the high potential electrode 10A or the low potential electrode 10B is arranged at one end in the X-direction (the direction in which the plurality of battery cells 10 line up), and the low potential electrode 10B or the high potential electrode 10A that is opposite in polarity to the electrode arranged at the one end is arranged at the other end in the X-direction in each of the battery modules 110a to 110d.

The end surface frame 92 provided in close proximity to the high potential electrode 10A is referred to as a one end surface frame 92A, and the end surface frame 92 provided in close proximity to the low potential electrode 10B is referred to as an other end surface frame 92B in each of the battery modules 110a to 110d. FPC boards 50 of the battery modules 110a, 110b, 110c, 110d are referred to as FPC boards 50a, 50b, 50c, 50d, respectively.

As shown in Fig. 16 (a), one detecting circuit 20 is provided in common for the two battery modules 110a, 110b in the module group 110A. The printed circuit board 21 including the detecting circuit 20 is attached to the other end surface frame 92B of the battery module 110b in the vicinity of the side surface portion 550b. In this state, ends of the two FPC boards 50b of the battery module 110b are connected to the printed circuit board 21.

The length of each of the FPC boards 50a of the battery module 110a is approximately twice the length of each of the FPC board 50b of the battery module 110b. The two FPC boards 50a of the battery module 110a extend in the X-direction on an upper surface of the battery module 110a, and further extend in the X-direction to overlap the FPC boards 50b, respectively, on an upper surface of the battery module 110b to be connected to the common printed circuit board 21.

In the battery modules 110a, 110b, the high potential electrodes 10A and the low potential electrodes 10B are positioned on the side of one end (the side of the side surface portion 550c of Fig. 15) in the Y-direction (the direction perpendicular to the direction in which the plurality of battery cells 10 line up).

In this case, the low potential electrode 10B of the battery module 110a and the high potential electrode 10A of the battery module 110b are in close proximity to each other on the side of the one end in the Y-direction. The high potential electrode 10A of the battery module 110a is positioned in the vicinity of the side surface portion 550d, and the low potential electrode 10B of the battery module 110b is positioned in the vicinity of the side surface portion 550b. The low potential electrode 10B of the battery module 110a and the high potential electrode 10A of the battery module 110b that are in close proximity to each other are connected through a strip-shaped bus bar 551.

As shown in Fig. 16 (b), one detecting circuit 20 is provided in common for the two battery modules 110c, 110d also in the module group 110B. The printed circuit board 21 including the detecting circuit 20 is attached to the one end surface frame 92A of the battery module 110d in the vicinity of the side surface portion 550b. In this state, ends of the two FPC boards 50d of the battery module 110d are connected to the printed circuit board 21.

The length of each of the FPC boards 50c of the battery module 110c is approximately twice the length of each of the FPC boards 50d of the battery module 110d. The two FPC boards 50c of the battery module 110c extend in the X-direction on an upper surface of the battery module 110c, and further extend in the X-direction to overlap the FPC boards 50d, respectively, on an upper surface of the battery module 110d to be connected to the common printed circuit board 21.

In the battery modules 110c, 110d, the high potential electrodes 10A and the low potential electrodes 10B are positioned on the side of the other end (the side of the side surface portion 550a of Fig. 15) in the Y-direction (the direction perpendicular to the direction in which the plurality of battery cells 10 line up).

In this case, the high potential electrode 10A of the battery module 110c and the low potential electrode 10B of the battery module 110d are in close proximity to each other on the side of the other end in the Y-direction. The low potential electrode 10B of the battery module 110c is positioned in the vicinity of the side surface portion 550d, and the high potential electrode 10A of the battery module 110d is positioned in the vicinity of the side surface portion 550b.

### (2) Connection of Power Supply Lines

Returning to Fig. 15, the low potential electrode 10B of the battery module 110c and the service plug 106 are electrically connected to each other through a power supply line D2 in the battery system 500A according to the present embodiment. The service plug 106 and the high potential electrode 10A of the battery module 110a are electrically connected to each other through a power supply line D3. In this case, the low potential electrode 10B of the battery module 110c, the service plug 106 and the high potential electrode 10A of the battery module 110a are positioned in the vicinity of the side surface portion 550d of the casing 550. This allows the length of each of the power supply lines D2, D3 to be reduced. This results in simplified wiring. The power supply lines D2, D3 correspond to the power supply lines 501 of Fig. 1.

As described above, the low potential electrode 10B of the battery module 110a and the high potential electrode 10A of the battery module 110b are electrically connected to each other through the bus bar 551. In this case, the low potential electrode 10B of the battery module 110a and the high potential electrode 10A of the battery module 110b are in close proximity to each other. Therefore, a comparatively short bus bar 551 can be used. The bus bar 551 corresponds to the power supply line 501 of Fig. 1.

The low potential electrode 10B of the battery module 110b and the high potential electrode 10A of the battery module 110d are electrically connected to each other through a power supply line D4. In this case, the low potential electrode 10B of the battery module 110b and the high potential electrode 10A of the battery module 110d are positioned in the vicinity of the side surface portion 550b of the casing 550. This allows the length of the power supply line D4 to be reduced. This results in simplified wiring. The power supply line D4 corresponds to the power supply line 501 of Fig. 1.

The contactor 102 and the high potential electrode 10A of the battery module 110c are electrically connected to each other through a power supply line D1. The contactor 102 and the low potential electrode 10B of the battery module 110d are electrically connected to each other through a power supply line D5. The power supply lines D1, D5 correspond to the power supply lines 501 of Fig. 1. Note that the two power supply lines D1, D5 are connected to the contactor 102 in this embodiment.

The contactor 102 is positioned at substantially the center in the X direction within the casing 550. Therefore, the low potential electrode 10B of the battery module 110d, the contactor 102 and the high potential electrode 10A of the battery module 110c are in close proximity to one another at substantially the center in the X-direction within the casing 550. This allows the length of each of the power supply lines D1, D5 to be reduced. This results in simplified wiring.

The contactor 102 is electrically connected to the HV connector 105 through power supply lines D6, D7. The HV connector 105 is connected to the load such as the motor of the electric vehicle.

When the contactor 102 is turned on, the battery module 110c is connected to the HV connector 105 through the power supply lines D1, D6 while the battery module 110d is connected to the HV connector 105 through the power supply lines D5, D7. That is, the battery modules 110a to 110d and the load connected to the HV connector 105 form a series circuit. Accordingly, electric power is supplied from the battery modules 110a to 11d to the load.

When the contactor 102 is turned off, the connection between the battery module 110c and the HV connector 105 and the connection between the battery module 110d and the HV connector 105 are cut off.

### (3) Connection of Communication Lines

As described above, the module groups 110A, 110B are each provided with the one printed circuit board 21 including the detecting circuit 20.

The battery ECU 101 is electrically connected to the printed circuit board 21 of the module group 110A through a communication line P1. The printed circuit board 21 of the module group 110A is electrically connected to the printed circuit board 21 of the module group 110B through a communication line P2. The printed circuit board 21 of the module group 110B is electrically connected to the battery ECU 101 through a communication line P3. The communication lines P1 to P3 constitute the bus 103 of Fig. 1.

In the following description, information about the plurality of battery cells 10 (the voltage, current and temperature) detected by the detecting circuit 20 is referred to as cell information.

As described above, the communication lines P1 to P3 are connected among the module groups 110A, 110B and the battery ECU 101, so that a given control signal is transmitted from the battery ECU 101 to the detecting circuit 20 of the module group 110A through the communication line P1. The cell information detected by the detecting circuit 20 of the module group 110A is given to the battery ECU 101 through the communication lines P2, P3.

A given control signal is transmitted from the battery ECU 101 to the detecting circuit 20 of the module group 110B through the communication lines P1, P2. The cell information detected by the detecting circuit 20 of the module group 110B is given to the battery ECU 101 through the communication line P3.

### (4) Effects of the Sixth Embodiment

As shown in Figs. 15, 16 (a) and 16 (b), the printed circuit boards 21 of the module groups 110A, 110B are each arranged in the vicinity of the side surface portion 550b of the casing 550. That is, the detecting circuits 20 of the module groups 110A, 110B are arranged adjacent to each other in the Y-direction. The battery ECU 101 is also arranged in the vicinity of the side surface portion 550b of the casing 550. This allows the length of each of the communication lines P1 to P3 to be reduced. This results in simplified wiring.

In the present embodiment, the detecting circuit 20 of the module group 110A is used in common for the two battery modules 110a, 110b, and the detecting circuit 20 of the module group 110B is used in common for the two battery modules 110c, 110d. The number of the detecting circuits 20 that communicate with the battery ECU 101 is reduced, so that the number of the communication lines P1 to P3 is also reduced. This results in further simplified wiring for communication.

As described above, the low potential electrode 10B of the battery module 110c, the service plug 106 and the high potential electrode 10A of the battery module 110a are positioned in the vicinity of the side surface portion 550d of the casing 550 in the present embodiment. This allows the length of each of the power supply lines D2, D3 to be reduced. The low potential electrode 10B of the battery module 110b and the high potential electrode 10A of the battery module 110d are positioned in the vicinity of the side surface portion 550b of the casing 550. This allows the length of the power supply line D4 to be reduced. The low potential electrode 10B of the battery module 110d, the contactor 102 and the high potential electrode 10A of the battery module 110c are in close proximity to each other at substantially the center in the X-direction within the casing 550. This allows the length of each of the power supply lines D1, D5 to be reduced. In this manner, the length of each of the power supply lines D1 to D5 can be reduced. This results in simplified wiring for supplying electric power to the load.

As a result, reduced cost, easier assembly and improved reliability of the entire battery system 500 are realized.

While description is made of the example where the detecting circuits 20 of the module groups 110A, 110B are provided at the other end surface frame 92B of the battery module 110b and the one end surface frame 92A of the battery module 110d, respectively, in the present embodiment, the present invention is not limited to this.

The detecting circuits 20 of the module groups 110A, 110B may be provided at other portions if the detecting circuits 20 are arranged adjacent to each other in the Y-direction.

For example, the detecting circuit 20 of the module group 110A is arranged between the two battery modules 110a, 110b, and the detecting circuit 20 of the module group 110B is arranged between the two battery modules 110c, 110d. Also in this case, the detecting circuits 20 of the module groups 110A, 110B are adjacent to each other in the Y-direction, thus simplifying the communication line between the two detecting circuits 20.

The detecting circuit 20 of the module group 110A is arranged on the upper surface of the battery module 110a, and the detecting circuit 20 of the module group 110B is arranged on the upper surface of the battery module 110c. Also in this case, the communication line is simplified.

### [7] Seventh Embodiment

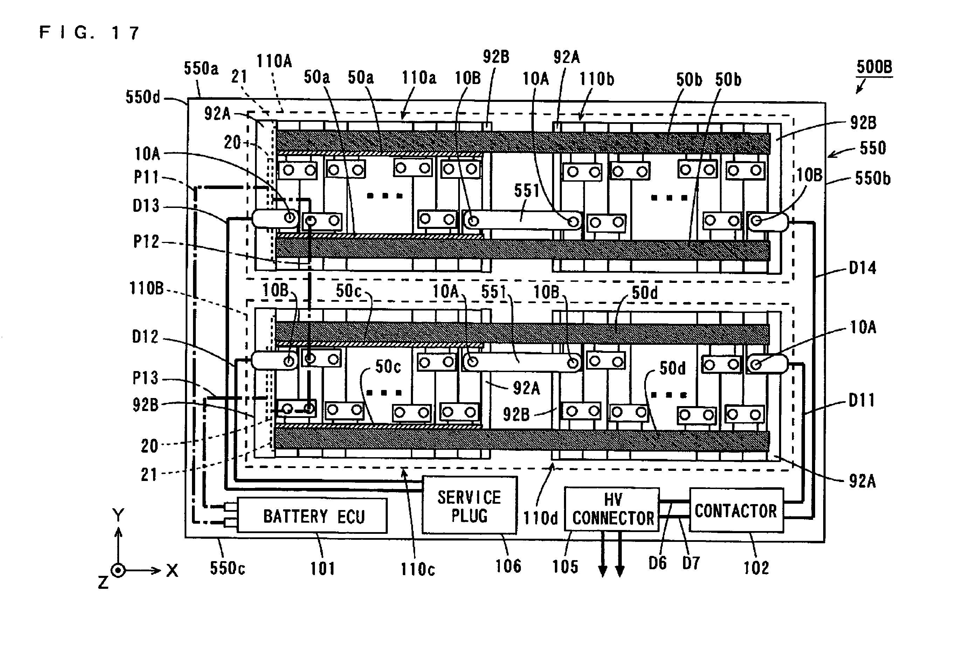

Description will be made of a battery system according to a seventh embodiment while referring to differences from the battery system 500A according to the sixth embodiment. Fig. 17 is a schematic plan view of the battery system according to the seventh embodiment.

### (1) Arrangement of the Components

As shown in Fig. 17, in the battery system 500B according to the seventh embodiment, the detecting circuits 20 of the module groups 110A, 110B are arranged in different positions from those in the battery system 500A of Fig. 15.

More specifically, the printed circuit board 21 including the detecting circuit 20 is attached to the one end surface frame 92A of the battery module 110a in the module group 110A. The printed circuit board 21 including the detecting circuit 20 is attached to the other end surface frame 92B of the battery module 110c in the module group 110B.

The contactor 102, the HV connector 105, the service plug 106 and the battery ECU 101 are arranged to line up in this order in the X-direction from the side surface portion 550b toward the side surface portion 550d in the portion between the module group 110B and the side surface portion 550c.

### (2) Connection of Power Supply Lines

The low potential electrode 10B of the battery module 110d and the high potential electrode 10A of the battery module 110c are electrically connected to each other through the strip-shaped bus bar 551 in the battery system 500B according to the present embodiment. The bus bar 551 corresponds to the power supply line 501 of Fig. 1. The low potential electrode 10B of the battery module 110c and the service plug 106 are electrically connected to each other through a power supply line D12. The service plug 106 and the high potential electrode 10A of the battery module 110a are electrically connected to each other through a power supply line D13. The power supply lines D12, D13 correspond to the power supply lines 501 of Fig. 1.

The low potential electrode 10B of the battery module 110a and the high potential electrode 10A of the battery module 110b are electrically connected to each other through the strip-shaped bus bar 551. The bus bar 551 corresponds to the power supply line 501 of Fig. 1. The low potential electrode 10B of the battery module 110b and the contactor 102 are electrically connected to each other through a power supply line D14. The contactor 102 and the high potential electrode 10A of the battery module 110d are electrically connected to each other through a power supply line D11. The power supply lines D11, D14 correspond to the power supply lines 501 of Fig. 1. Note that the two power supply lines D11, D14 are connected to the contactor 102 in this embodiment.

The contactor 102 is electrically connected to the HV connector 105 through the power supply lines D6, D7. The HV connector 105 is connected to the load such as the motor of the electric vehicle.

When the contactor 102 is turned on, the battery module 110d is connected to the HV connector 105 through the power supply lines D11, D6 while the battery module 110b is connected to the HV connector 105 through the power supply lines D14, D7. That is, the battery modules 110a to 110d and the load connected to the HV connector 105 form a series circuit. Accordingly, electric power is supplied from the battery modules 110a to 110d to the load.

### (3) Connection of Communication Lines

As described above, the module groups 110A, 110B are each provided with the one printed circuit board 21 including the detecting circuit 20.

The battery ECU 101 is electrically connected to the printed circuit board 21 of the module group 110A through a communication line P11. The printed circuit board 21 of the module group 110A is electrically connected to the printed circuit board 21 of the module group 110B through a communication line P12. The printed circuit board 21 of the module group 110B is electrically connected to the battery ECU 101 through a communication line P13. The communication lines P11 to P13 constitute the bus 103 of Fig. 1.

In this case, a given control signal is transmitted from the battery ECU 101 to the detecting circuit 20 of the module group 110A through the communication line P11. The cell information detected by the detecting circuit 20 of the module group 110A is given to the battery ECU 101 through the communication lines P12, P13.

A given control signal is transmitted from the battery ECU 101 to the detecting circuit 20 of the module group 110B through the communication lines P11, P12. The cell information detected by the detecting circuit 20 of the module group 110B is given to the battery ECU 101 through the communication line P13.

### (4) Effects of the Seventh Embodiment

In the present embodiment, a series circuit composed of the two battery modules 110a, 110b of the module group 110A and a series circuit composed of the two battery modules 110c, 110d of the module group 110B are connected to each other via the service plug 106.

The service plug 106 is turned off by a worker during maintenance of the battery system 500B, for example. When the service plug 106 is turned off, the series circuit composed of the battery modules 110a, 110b and the series circuit composed of the battery modules 110c, 110d are electrically separated from each other.

In this case, the total voltages are equal in the series circuit composed of the battery modules 110a, 110b and the series circuit composed of the battery modules 110c, 110d. This prevents a high voltage from being generated in the battery system 500B during maintenance.

### (5) Another Example of Connection of Communication Lines

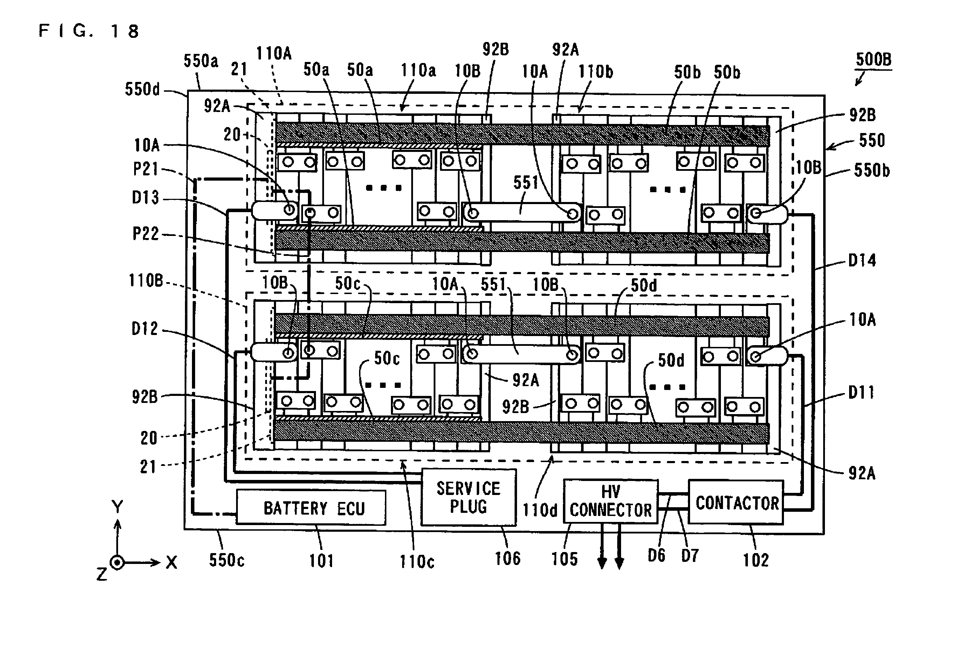

The detecting circuits 20 provided in the module groups 110A, 110B and the battery ECU 101 may be connected in the following manner. Fig. 18 is a schematic plan view showing another example of connection of communication lines in the battery system 500B according to the seventh embodiment.

In the example of Fig. 18, the battery ECU 101 is electrically connected to the printed circuit board 21 of the module group 110A through a communication line P21. The printed circuit board 21 of the module group 110A is electrically connected to the printed circuit board 21 of the module group 110B through a communication line P22. The bus 103 of Fig. 1 is constituted by the communication lines P21, P22.

In this case, a given control signal is transmitted from the battery ECU 101 to the detecting circuit 20 of the module group 110A through the communication line P21. The cell information detected by the detecting circuit 20 of the module group 110A is given to the battery ECU 101 through the communication lines P21.

A given control signal is transmitted from the battery ECU 101 to the detecting circuit 20 of the module group 110B through the communication lines P21, P22. The cell information detected by the detecting circuit 20 of the module group 110B is given to the battery ECU 101 through the communication lines P22, P21.

The number of the communication lines can be further reduced in this example. This causes the wiring for communication to be further simplified.

### [8] Eighth Embodiment

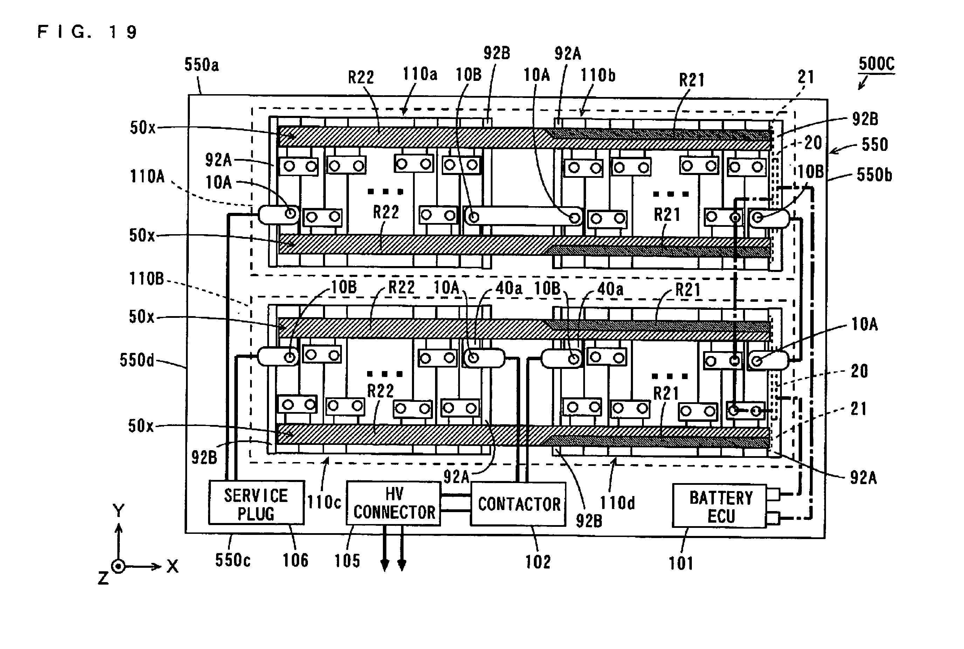

Description will be made of a battery system according to an eighth embodiment while referring to differences from the battery system 500A according to the sixth embodiment. Fig. 19 is a schematic plan view of the battery system according to the eighth embodiment.

### (1) Configuration of FPC Board

As shown in Fig. 19, two FPC boards 50x are used in common for the two battery modules 110a, 110b of the module group 110A in the battery system 500C according to the present embodiment. Similarly, two FPC boards 50x are used in common for the two battery modules 110c, 110d of the module group 110B. Details of the FPC boards 50x will be described.

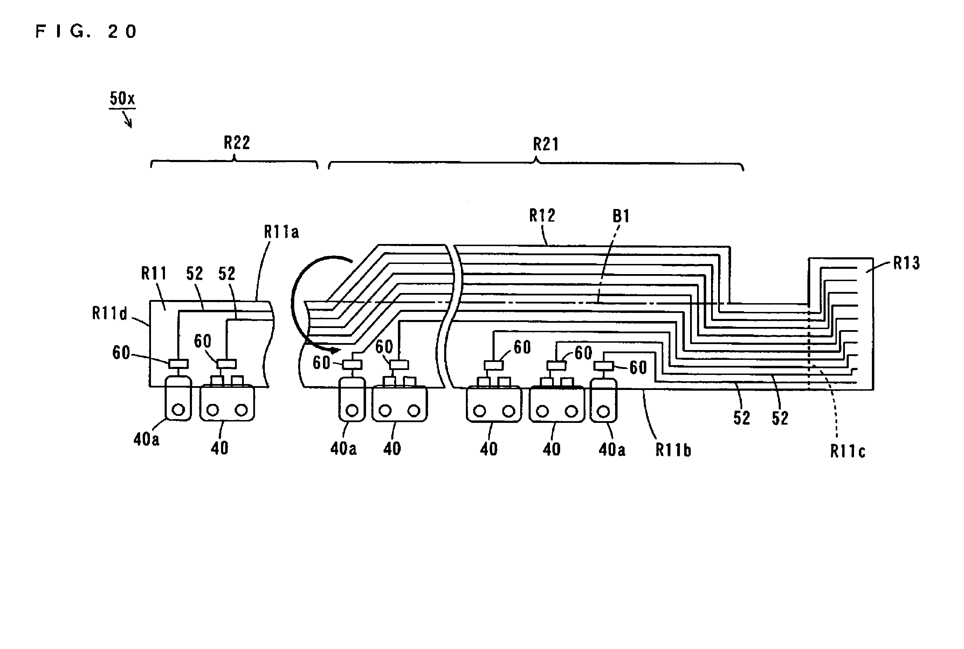

Fig. 20 is a plan view of the FPC board 50x used in the battery system 500C according to the eighth embodiment.

As shown in Fig. 20, the FPC board 50x has a strip-shaped first region R11, a strip-shaped second region R12 and a rectangular connection region R13. The plurality of bus bars 40, 40a are attached to the first region R11, and the plurality of conductor lines 52 are provided in the first region R11. The plurality of conductor lines 52 are provided in the second region R12. The connection region R13 is used for connection of the conductor lines 52 provided in the first and second regions R11, R12 to the printed circuit board 21 (Fig. 19).

Here, in the first region R11, one lateral side is referred to as a first lateral side R11a, and the other lateral side on the opposite side to the first lateral side R11a is referred to as a second lateral side R11b. Also, in the first region R11, one end side is referred to as a first end side R11c, and the other end side on the opposite side to the first end side R11c is referred to as a second end side R11d.

In this example, the length (the length in a longitudinal direction) of the first region R11 is approximately twice the length in the X-direction (the direction in which the plurality of battery cells 10 line up) of one battery module. The length (the length in the longitudinal direction) of the second region R12 is approximately equal to the length in the X-direction (the direction in which the plurality of battery cells 10 line up) of one battery module. Thus, the length (the length in the longitudinal direction) of the second region R12 is approximately half the length (the length in the longitudinal direction) of the first region R11.

In the FPC board 50x, the second region R12 is formed along the first lateral side R11a from substantially the center in the longitudinal direction of the first region R11 to the vicinity of the first end side R11c, thus being integrated with the first region R11. The boundary between the first region R11 and the second region R12, that is, part of the first lateral side R11a coincides with a bending line B1, described below.

The connection region R13 is formed along the first end side R11c of the first region R11, thus being integrated with the first region R11. Part of the connection region R13 projects sideward from the first region R11.

The plurality of bus bars 40, 40a are attached to a surface of the first region R11 so as to line up at given spacings along the second lateral side R11b of the first region R11. The plurality of PTC elements 60 are attached to the surface of the first region R11 at the same spacings as the spacings between the plurality of bus bars 40, 40a. In this state, the FPC board 50x is bent at the bending line B1 (see the thick arrow).

The FPC board 50x is valley-folded at the bending line B1, so that the second region R12 overlaps the first region R11.

Hereinafter, a region on the side of one end of the FPC board 50x including part of the first region R11 and the second region R12 is referred to as a one end region R21, and a region on the side of the other end of the FPC board 50x excluding the one end region R21 and the connection region R13 is referred to as an other end region R22. When the FPC board 50x is provided in the battery modules 110a, 110b, 110c, 110d, the one end region R21 and the other end region R22 are arranged such that distance thereof from the printed circuit board 21 is increased in this order, as described below.

Here, the plurality of conductor lines 52 extend parallel to one another along a longitudinal direction of the FPC board 50x from the plurality of PTC elements 60, respectively. Therefore, the number of the conductor lines 52 extending parallel to one another is increased in a region closer to the connection region R13. Thus, the number of the conductor lines 52 provided in the other end region R22 is smaller than the number of the conductor lines 52 provided in the one end region R21.

Therefore, the width (the length in a direction perpendicular to the longitudinal direction) of the other end region R22 is set smaller than the width (the length in the direction perpendicular to the longitudinal direction) of the one end region R21 in the FPC board 50x. Since the width and pitch of each of the plurality of conductor lines 52 need not be reduced, a short and heat generation in the conductor lines 52 can be sufficiently prevented. This reduces useless space in the other end region R22.

Returning to Fig. 19, the FPC boards 50x used in common for the two battery modules 110a, 110b are each provided such that the other end region R22 having the smaller width extends in the X-direction on an upper surface of the battery module 110a and the one end region R21 having the larger width extends in the X-direction on an upper surface of the battery module 110b including the detecting circuit 20. The FPC boards 50x used in common for the two battery modules 110c, 110d are each provided such that the other end region R22 having the smaller width extends in the X-direction on an upper surface of the battery module 110c and the one end region R21 having the larger width extends in the X-direction on an upper surface of the battery module 110d including the detecting circuit 20.

While the length of the second region R12 is approximately equal to the length in the X-direction (the direction in which the plurality of battery cells 10 line up) of the battery module in this example, the length of the second region R12 may be suitably changed according to the number of the conductor lines 52 and the arrangement thereof. That is, the second region R12 may be provided in a portion where the first region R11 cannot provide enough space for arranging increased number of the conductor lines 52, and may extend toward the vicinity of the connection region R13 (Fig. 20).

### (2) Effects of the Eighth Embodiment

The FPC boards 50x are used in common for the two battery modules in the foregoing manner, thereby preventing the increased number of components and simplifying the configuration. Since the width and pitch of each of the plurality of conductor lines 52 need not be reduced, a short and heat generation in the conductor lines 52 can be sufficiently prevented. As a result, reduced cost, easier assembly and improved reliability of the entire battery system 500C are realized.

### [9] Ninth Embodiment

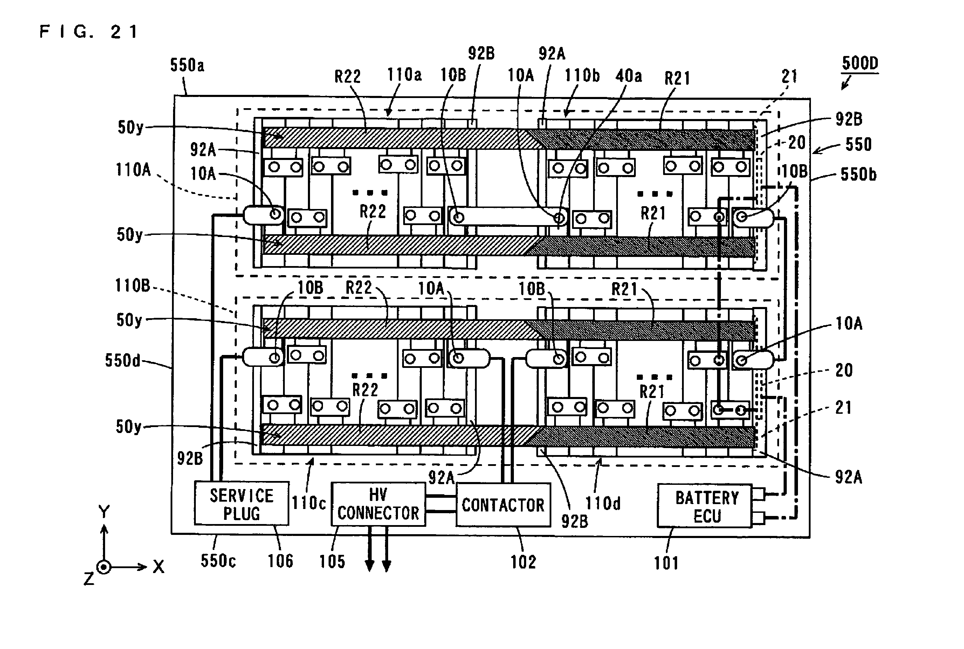

Description will be made of a battery system according to a ninth embodiment while referring to differences from the battery system 500C according to the eighth embodiment. Fig. 21 is a schematic plan view of the battery system according to the ninth embodiment.

### (1) Configuration of the FPC Board

As shown in Fig. 21, two FPC boards 50y are used in common for the two battery modules 110a, 110b of the module group 110A in the battery system 500D according to the present embodiment. Similarly, two FPC boards 50y are used in common for the two battery modules 110c, 110d of the module group 110B. Details of the FPC boards 50y will be described.

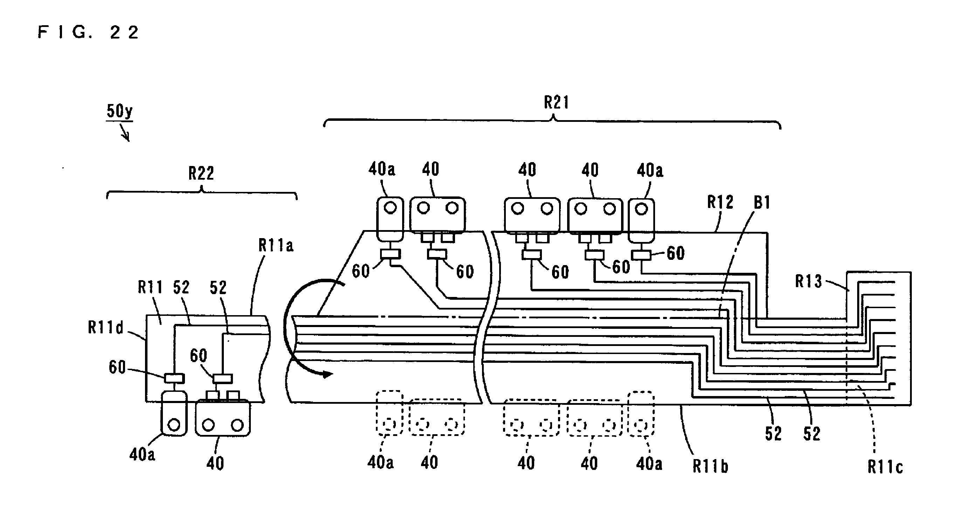

Fig. 22 is a plan view of the FPC board 50y used in the battery system 500D according to the ninth embodiment. Description is made of the FPC board 50y of Fig. 22 while referring to differences from the FPC board 50x of Fig. 20.

In the FPC board 50y, the first region R11 and the second region R12 have substantially the same widths (the lengths in the direction perpendicular to the longitudinal direction).

In the other end region R22, the plurality of bus bars 40, 40a are attached to a surface of the first region R11 so as to line up at given spacings along the second lateral side R11b of the first region R11. The plurality of PTC elements 60 are attached to the surface of the first region R11 at the same spacings as the spacings between the plurality of bus bars 40, 40a. The conductor line 52 connected to each PTC element 60 extends from the first region R11 to the connection region R13 while not passing through the second region R12.

In the one end region R21, the plurality of bus bars 40, 40a are attached to a surface of the second region R12 so as to line up at given spacings along one lateral side of the second region R12 (a lateral side on the opposite side to the bending line B1). The plurality of PTC elements 60 are attached to the surface of the second region R12 at the same spacings as the spacings between the plurality of bus bars 40, 40a. The conductor line 52 connected to each PTC element 60 extends from the second region R12 and passes through the first region R11 to reach the connection region R13.

In this state, the FPC board 50y is bent at the bending line B1 (see the thick arrow). Thus, the second region R12 overlaps the first region R11. As described above, the first region R11 and the second region R12 have substantially the same widths. Therefore, the plurality of bus bars 40, 40a attached to the second region R12 are arranged along the second lateral side R11b of the first region R11 in the one end region R21. Accordingly, all the bus bars 40, 40a are arranged at the given spacings along the second lateral side R11b of the first region R11 in the one end region R21 and the other end region R22 (see 40, 40a indicated by the dotted lines in Fig. 22).

Returning to Fig. 21, the FPC boards 50y used in common for the two battery modules 110a, 110b are each provided such that the other end region R22 having the smaller width extends in the X-direction on an upper surface of the battery module 110a and the one end region R21 having the larger width extends in the X-direction on an upper surface of the battery module 110b including the detecting circuit 20. The FPC boards 50y used in common for the two battery modules 110c, 110d are each provided such that the other end region R22 having the smaller width extends in the X-direction on an upper surface of the battery module 110c and the one end region R21 having the larger width extends in the X-direction on an upper surface of the battery module 110d including the detecting circuit 20.

Also in this example, while the length of the second region R12 is approximately equal to the length in the X-direction (the direction in which the plurality of battery cells 10 line up) of the battery module, the length of the second region R12 may be suitably changed according to the number of the conductor lines 52 and the arrangement thereof. That is, the second region R12 may be provided in a portion where the first region R11 cannot provide enough space for arranging increased number of the conductor lines 52, and may extend toward the vicinity of the connection region R13 (Fig. 22).

### (2) Effects of the Ninth Embodiment

The FPC board 50y of Fig. 22 has fewer portions of intersection of the bending line B1 and the conductor lines 52 as compared with the FPC board 50x of Fig. 20. Therefore, distortion occurs in fewer portions in the conductor lines 52 when the FPC board 50y is bent.

The FPC boards 50y are used in common for the two battery modules in the foregoing manner, thereby preventing the increased number of components and simplifying the configuration. Since the width and pitch of each of the plurality of conductor lines 52 need not be reduced, a short and heat generation in the conductor lines 52 can be sufficiently prevented. As a result, reduced cost, easier assembly and improved reliability of the entire battery system 500D are realized.

### [10] Tenth Embodiment

Description will be made of a battery system according to a tenth embodiment while referring to differences from the battery system 500 according to the first embodiment.

Each of module groups included in the battery system according to the tenth embodiment is mainly composed of two battery modules. The two battery modules used in the present embodiment each have a different configuration from that of the battery module 100 used in the first embodiment.

### (1) Configuration of One Battery Module

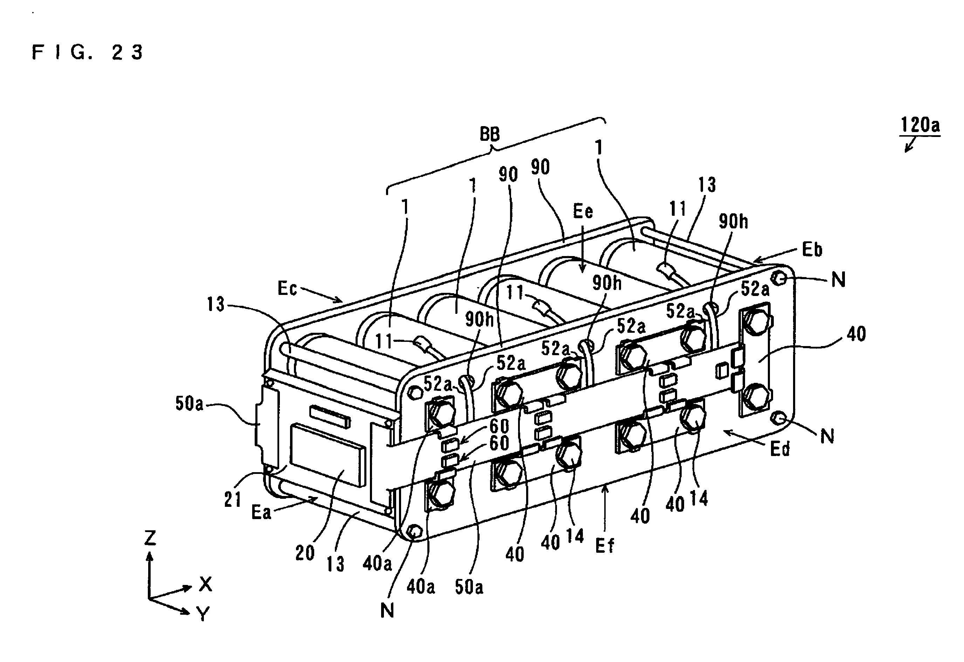

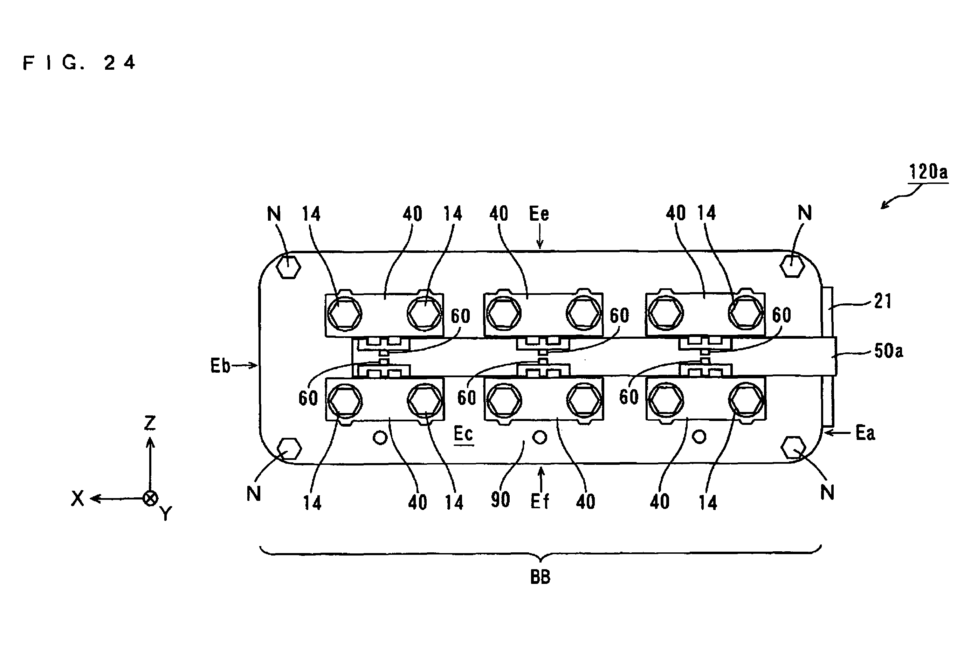

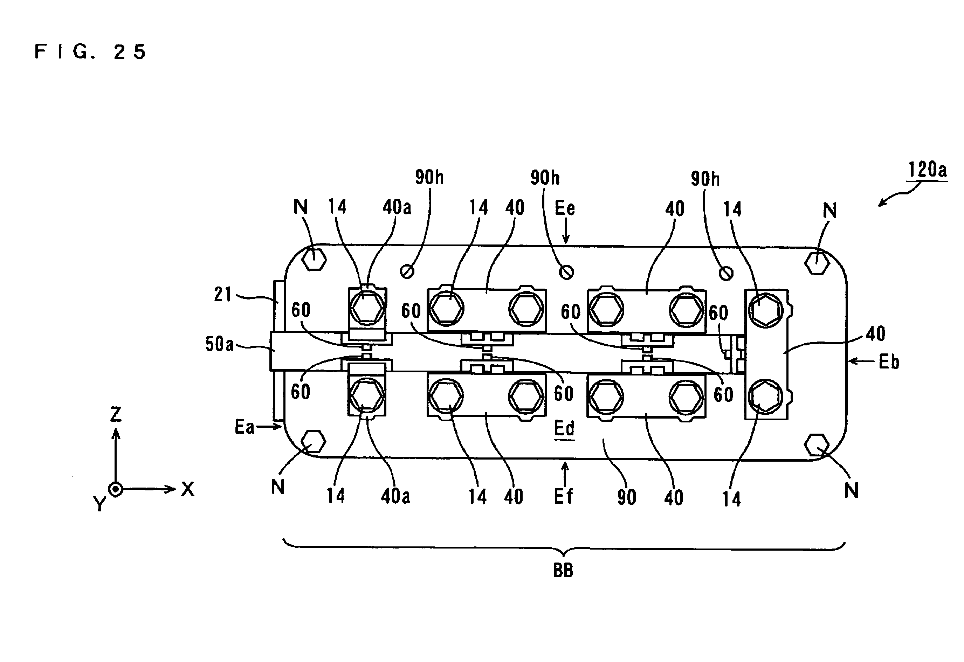

First, description is made of the configuration of one battery module of the two battery modules. Fig. 23 is an external perspective view showing one battery module used in the battery system according to the tenth embodiment, Fig. 24 is a view showing one side surface of the battery module 120a of Fig. 23, and Fig. 25 is a view showing the other side surface of the battery module 120a of Fig. 23.

As shown in Figs. 23 to 25, the battery module 120a includes a battery block BB, the printed circuit board 21 and the FPC boards 50a. The printed circuit board 21 is provided with the detecting circuit 20.

The battery block BB is mainly composed of a plurality of cylindrical battery cells 1, and a pair of battery holders 90 holding the battery cells 1. The outer shape of each battery cell 1 is a cylindrical shape having opposed end surfaces (i.e., a columnar shape). A plus electrode is formed on one end surface of the battery cell 1, and a minus electrode is formed on the other end surface of the battery cell 1.

The plurality of battery cells 1 are arranged parallel to one another such that the axial centers thereof are parallel to one another. In the example of Figs. 23 to 25, the axial center of each battery cell 1 is parallel to the Y-direction. Half (six in this example) of the battery cells 1 are arranged on an upper stage, and the other half (six in this example) of the battery cells 1 are arranged on a lower stage.

The plurality of battery cells 1 are arranged on the upper stage and the lower stage such that the positional relationship between the plus electrode and the minus electrode of each battery cell 1 is opposite to that of the adjacent battery cell 1. Thus, the plus electrode and the minus electrode of one battery cell 1 are respectively adjacent to the minus electrode and the plus electrode of the other battery cell 1 in the two adjacent battery cells 1.

The battery holders 90 are each formed of a substantially rectangular plate-like member made of resin, for example. The battery holder 90 has one surface and the other surface. Hereinafter, the one surface and the other surface of the battery holder 90 are referred to as an outer surface and an inner surface, respectively. The pair of battery holders 90 is arranged to sandwich the plurality of battery cells 1 therebetween. In this case, the one battery holder 90 is arranged to face one end surface of each battery cell 1, and the other battery holder 90 is arranged to face the other end surface of each battery cell 1.

Holes are formed at four corners of each battery holder 90, and ends of stick-like fastening members 13 are inserted into the holes. Male threads are formed at the ends of the fastening members 13. The plurality of battery cells 1 and the pair of battery holders 90 are integrally fixed by attaching nuts N at the ends of the fastening members 13. Three holes 90h are formed at equal spacings in the battery holder 90 along its longitudinal direction. Conductor lines 52a are inserted through the holes 90h, respectively. The longitudinal direction of the battery holder 90 is parallel to the X-direction in this example.

Here, it is assumed that a virtual rectangular parallelepiped surrounds the battery block BB. When the rectangular parallelepiped has six virtual planes, a virtual plane facing outer peripheral surfaces of the respective battery cells 1 positioned on the upper stage and the lower stage at one end in the X-direction is referred to as a side surface Ea of the battery block BB, and a virtual plane facing outer peripheral surfaces of the respective battery cells 1 positioned on the upper stage and the lower stage at the other end in the X-direction is referred to as a side surface Eb of the battery block BB.

Out of six virtual planes of the rectangular parallelepiped, a virtual plane facing one end surfaces in the Y-direction of the plurality of battery cells 1 is referred to as a side surface Ec of the battery block BB, and a virtual plane facing the other end surfaces in the Y-direction of the plurality of battery cells 1 is referred to as a side surface Ed of the battery block BB.

Out of six virtual planes of the rectangular parallelepiped, a virtual plane facing outer peripheral surfaces of the plurality of battery cells 1 on the upper stage is referred to as a side surface Ee of the battery block BB, and a virtual plane facing outer peripheral surfaces of the plurality of battery cells 1 on the lower stage is referred to as a side surface Ef of the battery block BB.

The side surfaces Ea, Eb of the battery block BB are perpendicular to a direction in which the plurality of battery cells 1 on the upper or lower stage are arranged (the X-direction). That is, the side surfaces Ea, Eb of the battery block BB are parallel to the Y-Z plane while facing each other. The side surfaces Ec, Ed of the battery block BB are perpendicular to an axial direction of each battery cell 1 (the Y-direction). That is, the side surfaces Ec, Ed of the battery block BB are parallel to the X-Z plane while facing each other. The side surfaces Ee, Ef of the battery block BB are parallel to the direction in which the plurality of battery cells 1 on the upper or lower stage are arranged (the X-direction) and the axial direction of each battery cell 1 (the Y-direction). That is, the side surfaces Ee, Ef of the battery block BB are parallel to the X-Y plane while facing each other.

One of the plus electrode and the minus electrode of each battery cell 1 is arranged at the side surface Ec of the battery block BB, and the other is arranged at the side surface Ed of the battery block BB.

In the battery block BB, the plurality of battery cells 1 are connected in series through the plurality of bus bars 40, 40a and hexagon head bolts 14. More specifically, a plurality of holes corresponding to the plurality of battery cells 1 on the upper stage and the lower stage are formed in each of the battery holders 90. The plus electrode and the minus electrode of each battery cell 1 are fitted in the corresponding holes formed in the pair of battery holders 90. This causes the plus electrode and the minus electrode of each battery cell 1 to project from the outer surfaces of the pair of battery holders 90.

As described above, the battery cells 1 are arranged such that the positional relationship between the plus electrode and the minus electrode of each battery cell 1 is opposite to that of the adjacent battery cell 1 in the battery block BB. Therefore, in two adjacent battery cells 1, the plus electrode of one battery cell 1 is in close proximity to the minus electrode of the other battery cell 1, and the minus electrode of the one battery cel1 1 is in close proximity to the plus electrode of the other battery cell 1. In this state, the bus bar 40 is attached to the plus electrode and the minus electrode being in close proximity to each other such that the plurality of battery cells 1 are connected in series.

In the following description, the closest battery cell 1 to the side surface Ea to the closest battery cell 1 to the side surface Eb of the six battery cells 1 arranged on the upper stage of the battery block BB are referred to as first to sixth battery cells 1. The closest battery cell 1 to the side surface Eb to the closest battery cell 1 to the side surface Ea of the six battery cells 1 arranged on the lower stage of the battery block BB are referred to as seventh to twelfth battery cells 1.

In this case, the common bus bar 40 is attached to the minus electrode of the first battery cell 1 and the plus electrode of the second battery cell 1. The common bus bar 40 is attached to the minus electrode of the second battery cell 1 and the plus electrode of the third battery cell 1. Similarly, the common bus bar 40 is attached to the minus electrode of each of the odd-numbered battery cells 1 and the plus electrode of each of the even-numbered battery cells 1 adjacent thereto. The common bus bar 40 is attached to the minus electrode of each of the even-numbered battery cells 1 and the plus electrode of each of the odd-numbered battery cells 1 adjacent thereto.

The bus bars 40a for connecting power lines from the exterior are respectively attached to the plus electrode of the first battery cell 1 and the minus electrode of the twelfth battery cell 1.

The printed circuit board 21 including the detecting circuit 20 is attached to the side surface Ea of the battery block BB.

The long-sized FPC board 50a is provided to extend from the side surface Ec to the side surface Ea of the battery block BB. The long-sized FPC board 50a is provided to extend from the side surface Ed to the side surface Ea of the battery block BB.

The above-mentioned FPC boards 50a have substantially the same configuration as the FPC board 50 used in the first to eighth embodiments. The PTC elements 60 are arranged in close proximity to the plurality of bus bars 40, 40a, respectively, on each of the FPC boards 50a.

As shown in Fig. 24, the one FPC board 50a is arranged to extend in the direction in which the plurality of battery cells 1 are arranged (the X-direction) at the center of the side surface Ec of the battery block BB. The FPC board 50a is connected in common to the plurality of bus bars 40. As shown in Fig. 25, the other FPC board 50a is arranged to extend in the direction in which the plurality of battery cells 1 are arranged (the X-direction) at the center of the side surface Ed of the battery block BB. The FPC board 50a is connected in common to the plurality of bus bars 40, 40a.

The FPC board 50a on the side surface Ec is bent at a right angle at one end of the side surface Ec of the battery block BB toward the side surface Ea to be connected to the printed circuit board 21. The FPC board 50a on the side surface Ed is bent at a right angle at one end of the side surface Ed of the battery block BB toward the side surface Ea to be connected to the printed circuit board 21.

As shown in Fig. 23, the plurality of thermistors 11 are attached to the battery block BB. The thermistors 11 are connected to the FPC boards 50a through the conductor lines 52a. The bus bars 40, 40a and the thermistors 11 of the battery module 120a are electrically connected to the printed circuit board 21 through the conductor lines formed in the FPC boards 50a.

### (2) Configuration of the Other Battery Module

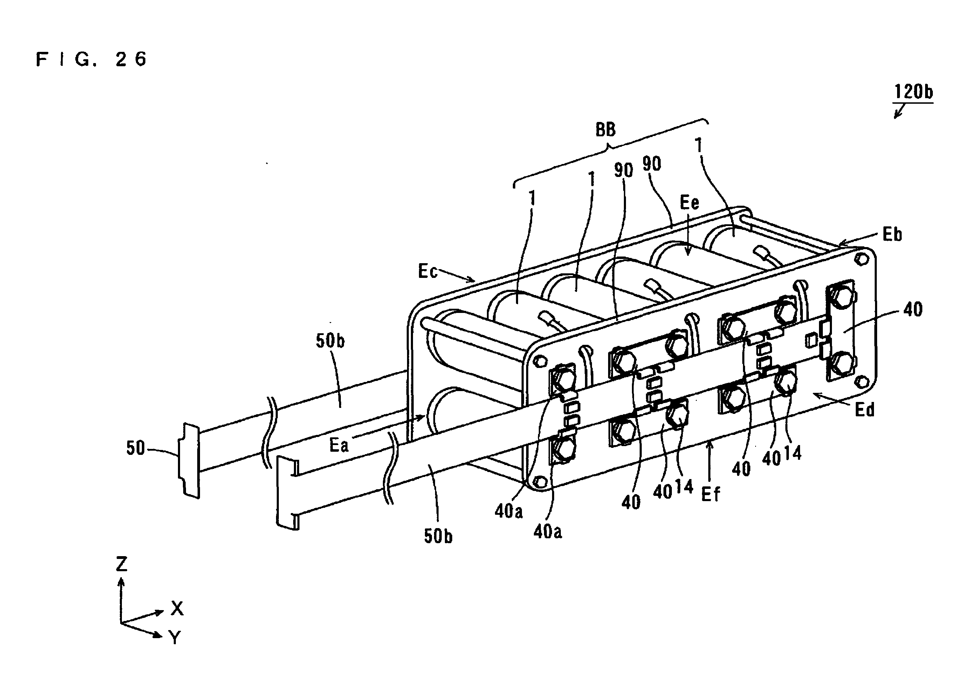

Next, description is made of the configuration of the other battery module of the two battery modules. Fig. 26 is an external perspective view showing the other battery module used in the battery system according to the tenth embodiment.

Description is made of the other battery module while referring to differences from the battery module 120a of Figs. 23 to 25.

As shown in Fig. 26, the printed circuit board 21 is not attached to a side surface Ea of a battery block BB in the battery module 120b. Therefore, the battery module 120b does not include the detecting circuit 20.

In the battery module 120b, the length of each of the two FPC boards 50b provided on side surfaces Ec, Ed of the battery block BB is approximately twice the length of each of the two FPC boards 50a of the battery module 120a.

### (3) Configuration of the Module Group

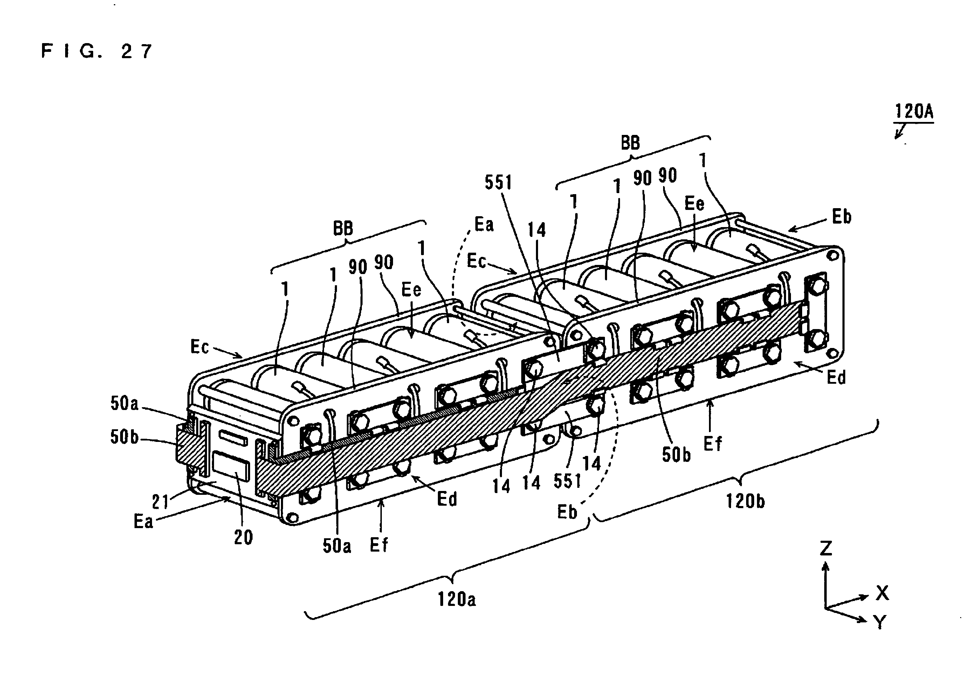

Fig. 27 is an external perspective view showing the arrangement of the module group included in the battery system according to the tenth embodiment.

As shown in Fig. 27, the two battery modules 120a, 120b are arranged in close proximity to each other while the side surface Eb of the battery block BB of the battery module 120a faces the side surface Ea of the battery block BB of the battery module 120b in the module group 120A. Accordingly, the battery modules 120a, 120b are arranged to line up along the direction in which the plurality of battery cells 1 are arranged (the X-direction).

In this state, the minus electrode of the sixth battery cell 1 of the battery module 120a and the plus electrode of the first battery cell 1 of the battery module 120b are connected to each other through the strip-shaped bus bar 551. The bus bar 551 corresponds to the power supply line 501 of Fig. 1. Similarly, the minus electrode of the twelfth battery cell 1 of the battery module 120b and the plus electrode of the seventh battery cell 1 of the battery module 120a are connected to each other through the strip-shaped bus bar 551. Accordingly, all the battery cells 1 of the battery modules 120a, 120b are connected in series.

In the module group 120A, the detecting circuit 20 and the printed circuit board 21 provided on the side surface Ea of the battery block BB of the battery module 120a are used in common for the two battery modules 120a, 120b.

As described above, the one FPC board 50a of the battery module 120a is provided to extend from the side surface Ec to the side surface Ea of the battery block BB to be connected to the printed circuit board 21. The other FPC board 50a of the battery module 120a is provided to extend from the side surface Ed to the side surface Ea of the battery block BB to be connected to the printed circuit board 21.

The one FPC board 50b of the battery module 120b extends in the X-direction on the side surface Ec of the battery module 120b, and further extends in the X-direction to overlap the FPC board 50a on the side surface Ec of the battery module 120a to be connected to the common printed circuit board 21.

The other FPC board 50b of the battery module 120b extends in the X-direction on the side surface Ed of the battery module 120b, and further extends in the X-direction to overlap the FPC board 50a on the side surface Ed of the battery module 120a to be connected to the common printed circuit board 21.

In this manner, the four FPC boards 50a, 50b are connected to the printed circuit board 21.

### (4) Effects of the Tenth Embodiment

As described above, the detecting circuit 20 can be used in common for the two battery modules 120a, 120b even though the battery modules 120a, 120b are composed of the battery cells 1 each having the columnar shape.

Also in this case, the number of the detecting circuits 20 can be reduced and the wiring for communication can be simplified. Accordingly, reduced cost, easier assembly and improved reliability of the entire battery system are realized.

### [11] Eleventh Embodiment

Hereinafter, description will be made of an electric vehicle according to an eleventh embodiment. The electric vehicle according to the present embodiment includes the battery system according to any of the first to tenth embodiments. An electric automobile is described as one example of the electric vehicle in the following paragraphs.

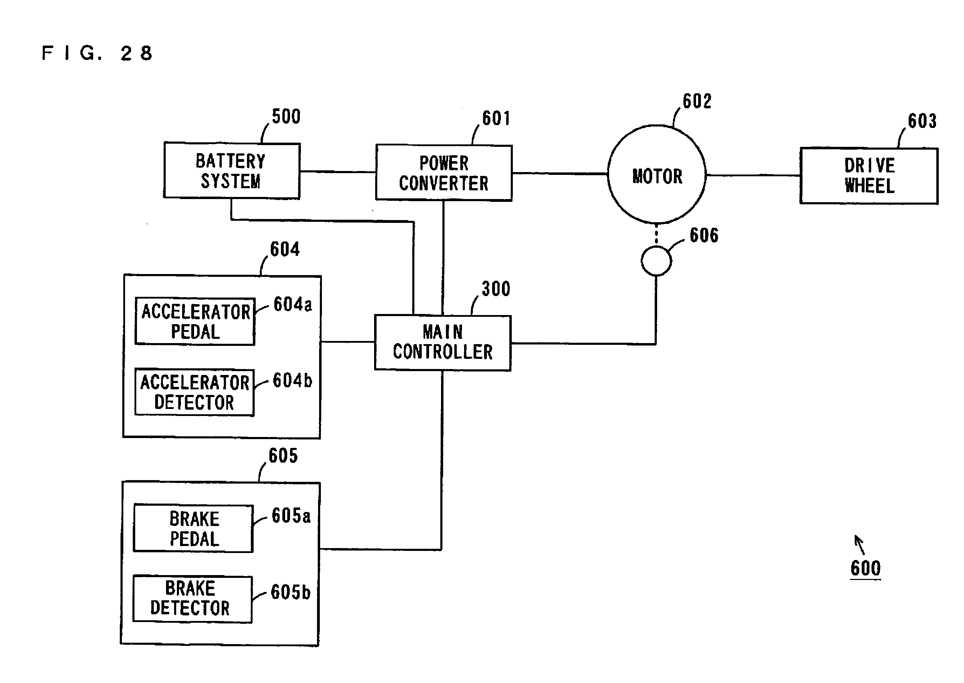

Fig. 28 is a block diagram showing the configuration of an electric automobile including the battery system 500 of Fig. 1. As shown in Fig. 28, the electric automobile 600 according to the present embodiment includes the main controller 300 and the battery system 500 of Fig. 1, a power converter 601, a motor 602, a drive wheel 603, an accelerator system 604, a brake system 605, and a rotational speed sensor 606. When the motor 602 is an alternate current (AC) motor, the power converter 601 includes an inverter circuit.

In the present embodiment, the battery system 500 is connected to the motor 602 via the power converter 601 while being connected to the main controller 300. As described in the foregoing, the main controller 300 is provided with the charged capacity of the plurality of battery modules 100 (Fig. 1) and the value of the current flowing through the battery modules 100 from the battery ECU 101 (Fig. 1) constituting the battery system 500. Moreover, each of the accelerator system 604, the brake system 605 and the rotational speed sensor 606 is connected to the main controller 300. The main controller 300 is composed of a CPU and a memory or composed of a microcomputer, for example.

The accelerator system 604 includes an accelerator pedal 604a included in the electric automobile 600 and an accelerator detector 604b that detects an operation amount (depression amount) of the accelerator pedal 604a. When the accelerator pedal 604a is operated by a driver, the accelerator detector 604b detects the operation amount of the accelerator pedal 604a. Note that a state of the accelerator pedal 604a when not being operated by the driver is set as a reference. The detected operation amount of the accelerator pedal 604a is given to the main controller 300.

The brake system 605 includes a brake pedal 605a provided in the electric automobile 600 and a brake detector 605b that detects an operation amount (depression amount) of the brake pedal 605a by the driver. When the brake pedal 605a is operated by the driver, the operation amount is detected by the brake detector 605b. The detected operation amount of the brake pedal 605a is given to the main controller 300.

The rotational speed sensor 606 detects a rotational speed of the motor 602. The detected rotational speed is given to the main controller 300.

As described in the foregoing, the charged capacity of the battery modules 100, the value of the current flowing through the battery modules 100, the operation amount of the accelerator pedal 604a, the operation amount of the brake pedal 605a and the rotational speed of the motor 602 are given to the main controller 300. The main controller 300 controls charge / discharge of the battery modules 100 and power conversion by the power converter 601 based on the information.

Electric power generated by the battery modules 100 is supplied from the battery system 500 to the power converter 601 at the time of starting and accelerating the electric automobile 600 based on the accelerator operation, for example.

Furthermore, the main controller 300 calculates a torque (commanded torque) to be transmitted to the drive wheel 603 based on the given operation amount of the accelerator pedal 604a, and gives a control signal based on the commanded torque to the power converter 601.

The power converter 601 receives the control signal, and then converts the electric power supplied from the battery system 500 into electric power (driving power) required for driving the drive wheel 603. Accordingly, the driving power converted by the power converter 601 is supplied to the motor 602, and the torque of the motor 602 based on the driving power is transmitted to the drive wheel 603.

Meanwhile, the motor 602 functions as a power generation system at the time of decelerating the electric automobile 600 based on the brake operation. In this case, the power converter 601 converts regenerated electric power generated by the motor 602 to electric power suitable for charging the battery modules 100, and supplies the electric power to the battery module 100. This causes the battery modules 100 to be charged.

As described above, the electric automobile 600 according to the present embodiment is provided with the battery system according to any of the first to tenth embodiments. Accordingly, the complicated configuration and increased cost can be suppressed while the capacity can be increased in the battery system. This allows for increased driving time and reduced cost of the electric vehicle.

### [12] Other Embodiments

(1) While the one detecting circuit 20 is used in common for the two or three battery modules in the battery systems 500, 500A to 500D according to the foregoing embodiments, the present invention is not limited to this. For example, the one detecting circuit 20 may be used in common for four or more battery modules. In this case, the number of the detecting circuits 20 can be further reduced as compared with the battery systems according to the foregoing embodiments. Thus, the configuration of the battery system is further simplified, and further reduced cost is realized. The number of the detecting circuits 20 that communicate with the battery ECU 101 of Fig. 1 is reduced, thereby simplifying the wiring for communication. Accordingly, further reduced cost, easier assembly and improved reliability of the entire battery system 500 are realized.
(2) While the two or three battery modules are two-dimensionally arranged in the battery systems 500, 500A to 500D according to the foregoing embodiments, the present invention is not limited to this. The battery modules may be three-dimensionally arranged depending on a space for arranging the battery system 500, for example.
(3) While the plurality of bus bars 40, 40a are attached to the plus electrodes 10a and the minus electrodes 10b of the plurality of battery cells 10 using the nuts in the battery systems 500, 500A to 500D according to the first to ninth embodiments, the present invention is not limited to this. The plurality of bus bars 40, 40a may be attached to the plus electrodes 10a and the minus electrodes 10b of the plurality of battery cells 10 by laser welding, other types of welding or caulking, for example.
(4) While the plurality of bus bars 40, 40a are connected to the lateral side close to the inside of each of the two FPC boards 50 that extend in the X-direction (the direction in which the plurality of battery cells 10 line up) so as to line up at the given spacings on the upper surface of the battery module in the battery systems 500, 500A to 500D according to the first to ninth embodiments, the present invention is not limited to this.
   The plurality of bus bars 40, 40a may be connected to the lateral side close to the outside of each of the two FPC boards 50 so as to line up at the given spacings if the plus electrode 10a and the minus electrode 10b of each battery cell 10 are arranged in close proximity to the pair of side surfaces, which extend along the X-direction, of the battery module, for example.
(5) While the plurality of detecting circuits 20 and the battery ECU 101 are connected to one another through the three communication lines in the battery systems according to the sixth, eighth and ninth embodiments, the present invention is not limited to this. As described in the another example of connection of the communication lines in the seventh embodiment, the plurality of detecting circuits 20 may be connected to the battery ECU 101 through two communication lines in a daisy chain mode also in the battery systems according to the sixth, eighth and ninth embodiments. In this case, the wiring for communication is further simplified.
(6) While the battery cells 10 each having the flat and substantially rectangular parallelepiped shape or the battery cells 1 each having the columnar shape are used as the battery cells constituting the battery module in the foregoing embodiments, the present invention is not limited to this. Laminate-type battery cells may be used as the battery cells constituting the battery module.
   The laminate-type battery cell is prepared as follows, for example. First, a cell element in which a positive electrode and a negative electrode are arranged with a separator sandwiched therebetween is housed in a bag made of a resin film. Then, the bag with the cell element housed therein is sealed, and the enclosed space is filled with an electrolytic solution. In this manner, the laminate-type battery cell is completed.

### [13] Correspondences between Elements in the Claims and Parts in Embodiments

In the following paragraphs, non-limiting examples of correspondences between various elements recited in the claims below and those described above with respect to various preferred embodiments of the present invention are explained.

In the foregoing embodiments, the detecting circuit 20 is an example of a voltage detector, the end surface frame 92 and the holder 20H are examples of a holding member, the bus bars 40, 40a are examples of a connecting member, the FPC board 50 is an example of a flexible member, and the conductor lines 51, 52 are examples of a voltage detection line.

The X-direction is an example of a first direction, the Y-direction is an example of a second direction, the battery modules 110a, 110b are examples of a first battery module, and the battery modules 110c, 110d are examples of a second battery module.

The module groups 110A, 110B are examples of first and second battery module groups, respectively, and the detecting circuit 20 of the module group 110A is an example of a first voltage detector, and the detecting circuit 20 of the module group 110B is an example of a second voltage detector.

As each of various elements recited in the claims, various other elements having configurations or functions described in the claims can be also used.

While preferred embodiments of the present invention have been described above, it is to be understood that variations and modifications will be apparent to those skilled in the art without departing the scope and spirit of the present invention. The scope of the present invention, therefore, is to be determined solely by the following claims, as interpreted by the description and drawings.

## Claims

1. A battery system comprising:
a plurality of battery modules each including a plurality of battery cells; and
a voltage detector that is used in common for said plurality of battery modules and detects a terminal voltage of each battery cell.

2. The battery system according to claim 1, wherein said voltage detector is arranged between any ones of said plurality of battery modules and held by a holding member.

3. The battery system according to claim 2, wherein said holding member is integrated with any of said plurality of battery modules.

4. The battery system according to claim 1, further comprising a holding member arranged to hold said voltage detector, wherein
each of said plurality of battery modules is arranged adjacent to another battery module,
and
said holding member is provided in a position, which is not a position between adjacent battery modules of said plurality of battery modules.

5. The battery system according to claim 4, wherein
said holding member is integrated with any of said plurality of battery modules.

6. The battery system according to claim 1, wherein
each battery module includes:
a connecting member arranged to connect electrodes of adjacent battery cells to each other;
a flexible member attached to said connecting member; and
a plurality of voltage detection lines that are provided in said flexible member and connected between said voltage detector and said connecting member.

7. The battery system according to claim 1, wherein
first and second battery module groups each including said plurality of battery modules are formed,
said voltage detector is provided in each of said first and second battery module groups as each of first and second voltage detectors,
said first voltage detector is used in common for said plurality of battery modules of said first battery module group, and detects the terminal voltage of each battery cell of said first battery module group,
said second voltage detector is used in common for said plurality of battery modules of said second battery module group, and detects the terminal voltage of each battery cell of said second battery module group,
said plurality of battery modules of said first battery module group are arranged along a first direction,
said plurality of battery modules of said second battery module group are arranged along the first direction,
said first and second battery module groups are arranged adjacent to each other in a second direction perpendicular to said first direction, and
said first and second voltage detectors are arranged adjacent to each other in said second direction, and connected so as to communicate with each other through a communication line.

8. An electric vehicle comprising:
the battery system according to claim 1;
a motor driven by electric power supplied from said plurality of battery modules of said battery system; and
a drive wheel rotated by a torque generated by said motor.
